# FASCICULE DE BREVET EUROPEEN

(11) **EP 3 010 022 B1**
(45) Date de publication et mention de la délivrance du brevet: **07.08.2019**
(21) Numéro de dépôt: 15189612.3
(22) Date de dépôt: 13.10.2015
(51) Int. Cl.: G11C 11/419, G11C 11/412, H01L 27/11, G11C 11/413

(54) **CELLULE MEMOIRE A TRANSISTORS DE LECTURE DE TYPE TFET ET MOSFET**
SPEICHERZELLE MIT LESE-TRANSISTOREN VOM TYP TFET UND MOSFET
MEMORY CELL WITH MOSFET AND TFET READING TRANSISTORS

(30) Priorité: 17.10.2014 FR 1459985
(43) Date de publication de la demande: 20.04.2016
(73) Titulaire: Commissariat à l'Énergie Atomique et aux Énergies Alternatives, 75015 Paris (FR)
(72) Inventeur: THOMAS, Olivier, 38420 Revel (FR); ANGHEL, Costin, 92170 Vanves (FR); MAKOSIEJ, Adam, 38000 Grenoble (FR)
(74) Mandataire: Brevalex

(56) Documents cités:
- US-B2- 8 320 163
- US-B2- 8 638 591
- SINGH J ET AL: "A novel Si-Tunnel FET based SRAM design for ultra low-power 0.3V VDD applications", DESIGN AUTOMATION CONFERENCE (ASP-DAC), 2010 15TH ASIA AND SOUTH PACIFIC, IEEE, PISCATAWAY, NJ, USA, 18 janvier 2010 (2010-01-18), pages 181-186, XP031641469, ISBN: 978-1-4244-5765-6
- XUEBEI YANG ET AL: "Robust 6T Si tunneling transistor SRAM design", DESIGN, AUTOMATION&TEST IN EUROPE CONFERENCE&EXHIBITION (DATE), 2011, IEEE, 14 mars 2011 (2011-03-14), pages 1-6, XP031863689, ISBN: 978-1-61284-208-0
- MOOKERJEA S ET AL: "Experimental demonstration of 100nm channel length In0.53Ga0.47As-based vertical inter-band tunnel field effect transistors (TFETs) for ultra low-power logic and SRAM applications", ELECTRON DEVICES MEETING (IEDM), 2009 IEEE INTERNATIONAL, IEEE, PISCATAWAY, NJ, USA, 7 décembre 2009 (2009-12-07), pages 1-3, XP031644537, ISBN: 978-1-4244-5639-0
- YOONMYUNG LEE ET AL: "Low-Power Circuit Analysis and Design Based on Heterojunction Tunneling Transistors (HETTs)", IEEE TRANSACTIONS ON VERY LARGE SCALE INTEGRATION (VLSI) SYSTEMS, IEEE SERVICE CENTER, PISCATAWAY, NJ, USA, vol. 21, no. 9, 1 septembre 2013 (2013-09-01), pages 1632-1643, XP011522600, ISSN: 1063-8210, DOI: 10.1109/TVLSI.2012.2213103

## Description

### DOMAINE TECHNIQUE ET ART ANTÉRIEUR

L'invention concerne le domaine des cellules mémoires de type SRAM.

Une cellule mémoire de type SRAM comporte généralement plusieurs transistors CMOS de mémorisation reliés entre eux en formant un élément bistable composé de deux inverseurs montés tête-bêche (la sortie du premier inverseur est reliée à l'entrée du deuxième inverseur, et la sortie du deuxième inverseur est reliée à l'entrée du premier inverseur) et permettant de réaliser une mémorisation d'un bit.

Le document [1] « Stable SRAM Cell Design for the 32 nm Node and Beyond » de L. Chang et al., Proc. Of Symposium on VLSI Technology, 2005, décrit une cellule mémoire de type SRAM comportant huit transistors CMOS. Quatre des huit transistors CMOS forment l'élément bistable, deux autres des huit transistors CMOS correspondent à des transistors d'accès en écriture et forment un port d'écriture de la cellule mémoire, et les deux derniers transistors CMOS correspondent à des transistors d'accès en lecture et forment un port de lecture de la cellule mémoire. Un premier des deux transistors CMOS du port de lecture comporte sa grille reliée à l'entrée d'un des deux inverseurs de l'élément bistable, sa source reliée à un potentiel de référence, et son drain relié à la source du deuxième des deux transistors CMOS du port de lecture. Le deuxième des deux transistors CMOS du port de lecture comporte son drain relié à une ligne de bit de lecture (sur laquelle un potentiel électrique d'alimentation V_{DD} est appliqué préalablement à une opération de lecture afin qu'un courant puisse circuler à travers les deux transistors CMOS du port de lecture lors d'une opération de lecture du bit mémorisé) et sa grille reliée à une ligne de mot de lecture qui permet de commander le début de l'opération de lecture via l'application d'un signal de commande de lecture sur cette grille.

Un tel port de lecture a toutefois pour inconvénients d'avoir des courants de fuite importants, et ne permet pas de réaliser un entrelacement de bits entre plusieurs cellules mémoires interconnectées. De plus, la consommation électrique d'une telle cellule mémoire est importante.

Afin de réduire la consommation électrique de ce type de cellule mémoire, plusieurs documents proposent d'utiliser des transistors de type TFET (« Tunnel Field-Effect Transistor ») à la place des transistors CMOS pour réaliser des cellules mémoires de type SRAM.

Le document [2] « Low-Power Circuit Analysis and Design Based on Heterojunction Tunneling Transistors (HETTs) » de Y. Lee et al., Very Large Scale Integration (VLSI) Systems, IEEE Transactions on, vol.21, n°9, pp. 1632-1643, 9 septembre 2013, décrit la réalisation d'une cellule mémoire de type SRAM comportant quatre transistors TFET (deux de type n et deux de type p) à hétérojonctions formant un élément bistable. Deux autres transistors d'accès TFET de type n sont couplés à l'élément bistable, chacun comportant son drain relié à l'entrée d'un des deux inverseurs de l'élément bistable, et forment le port d'écriture de la cellule mémoire. Un autre transistor TFET de type n est utilisé pour former un port de lecture distinct du port d'écriture.

Une telle cellule mémoire présente toutefois plusieurs inconvénients :
- faibles marges de bruit ;
- courants de fuite importants au niveau du port d'écriture et du port de lecture ;
- pas d'entrelacement de bits possible entre plusieurs cellules mémoires interconnectées ;
- courant limité à travers le transistor TFET du port de lecture.

Le document [3] « A Comparative Analysis of Tunneling FET Circuit Switching Characteristics and SRAM Stability and Performance » de Y.-N Chen et al., Proc. Of European Solid State Devices Conférence (ESSDERC), 2012, décrit une cellule mémoire de type SRAM proche de celle décrite dans le document [2], mais dont le port de lecture est formé par deux transistors TFET de type n. Un premier des deux transistors TFET du port de lecture comporte sa grille reliée à l'entrée d'un des deux inverseurs de l'élément bistable, sa source reliée à un potentiel électrique de référence, et son drain relié à la source du deuxième des deux transistors TFET du port de lecture. Le deuxième des deux transistors TFET du port de lecture comporte son drain relié à la ligne de bit de lecture et sa grille reliée à la ligne de mot de lecture.

Une telle cellule mémoire présente également plusieurs inconvénients, notamment :
- pas d'entrelacement de bits possible ;
- vitesse de lecture limitée en raison des deux transistors TFET du port de lecture qui sont disposés le long du trajet de décharge du courant de lecture depuis la ligne de bit de lecture jusqu'au potentiel électrique de référence.

US8638591 B2 divulgue une cellule mémoire de type SRAM en transistors de mémorisation TFET lesquelles sont couplés à un port de lecture comprenant un transistor TFET de lecture.

### EXPOSÉ DE L'INVENTION

Un but de la présente invention est de proposer un nouveau type de cellule mémoire résolvant au moins en partie les problèmes des cellules mémoires de l'art antérieur précédemment décrites, et dont le port de lecture permet une lecture rapide de l'état du bit mémorisé dans la cellule tout en réduisant les courants de fuite.

Pour cela, la présente invention propose une cellule mémoire de type SRAM, comportant au moins :
- des transistors de mémorisation TFET et/ou CMOS formant un point mémoire au niveau duquel un bit est destiné à être mémorisé ;
- un port de lecture comprenant au moins un transistor MOS de lecture, un transistor TFET de lecture, une borne d'alimentation électrique et une ligne de bit de lecture dont un potentiel électrique est destiné à varier selon la valeur du bit mémorisé lors d'une lecture du bit mémorisé, et tel que :
- la grille du transistor MOS de lecture est reliée au point mémoire, et la grille du transistor TFET de lecture est apte à recevoir un signal de commande de lecture du bit mémorisé ;
- une première électrode du transistor MOS de lecture, correspondant à une source ou un drain du transistor MOS de lecture, est reliée à la borne d'alimentation électrique ;
- une deuxième électrode du transistor MOS de lecture, correspondant respectivement au drain ou à la source du transistor MOS de lecture, est reliée à une première électrode du transistor TFET de lecture correspondant à une source ou un drain du transistor TFET de lecture ;
- une deuxième électrode du transistor TFET de lecture, correspondant respectivement au drain ou à la source du transistor TFET de lecture, est reliée à la ligne de bit de lecture.

L'utilisation conjointe d'un transistor MOS et d'un transistor TFET au sein du port de lecture permet à la cellule mémoire de présenter de faibles courants de fuite au niveau du port de lecture car la présence du transistor TFET dans le chemin allant de la ligne de bit de lecture à la borne d'alimentation électrique permet de réduire fortement ces courants de fuite par rapport à un port de lecture comportant uniquement des transistors MOS. Cela permet à la cellule mémoire selon l'invention d'avoir une consommation électrique inférieure à celle des cellules mémoires de l'art antérieur. La faible capacité formée par le transistor TFET qui est relié à la ligne de bit de lecture contribue également à la réduction des courants de fuite dans le port de lecture, et cela sans pénaliser la vitesse de lecture par rapport à un port de lecture qui serait formé uniquement de transistors MOS. La vitesse de lecture obtenue est en outre supérieure à celle d'un port de lecture formé uniquement de transistors TFET.

Les transistors de la cellule mémoire peuvent être en silicium ou comporter un ou plusieurs semi-conducteurs autres que le silicium.

La première électrode du transistor MOS de lecture peut correspondre à la source du transistor MOS de lecture. Dans cette configuration, la source du transistor MOS de lecture est reliée à la borne d'alimentation électrique, ce qui autorise qu'un courant plus important circule entre la ligne de bit de lecture et la borne d'alimentation électrique, et permet donc d'obtenir une plus grande vitesse de lecture du bit mémorisé dans la cellule mémoire.

La cellule mémoire peut comporter en outre des moyens de polarisation du port de lecture, et, lorsque le transistor MOS de lecture est de type n, les moyens de polarisation du port de lecture peuvent être aptes à appliquer un potentiel électrique de référence (Vss, correspondant par exemple à un potentiel électrique nul) sur la borne d'alimentation électrique (la borne d'alimentation électrique pouvant correspondre dans ce cas à la masse), ou, lorsque le transistor MOS de lecture est de type p, les moyens de polarisation du port de lecture peuvent être aptes à appliquer un potentiel électrique d'alimentation (V_{DD}, correspondant par exemple au potentiel électrique positif alimentant électriquement la cellule mémoire) sur la borne d'alimentation électrique.

Les moyens de polarisation du port de lecture peuvent être aptes à appliquer un potentiel électrique de référence sur la borne d'alimentation électrique tel que lors de la lecture du bit mémorisé, un courant de lecture circule à travers le transistor TFET de lecture et le transistor MOS de lecture depuis la ligne de bit de lecture jusqu'à la borne d'alimentation électrique, ou aptes à appliquer un potentiel électrique d'alimentation sur la borne d'alimentation électrique tel que lors de la lecture du bit mémorisé, un courant de lecture circule à travers le transistor MOS de lecture et le transistor TFET de lecture depuis la borne d'alimentation électrique jusqu'à la ligne de bit de lecture.

Les transistors de mémorisation peuvent correspondre à au moins des premier et deuxième transistors TFET de mémorisation reliés en série l'un à l'autre tels qu'une liaison entre une première électrode du premier transistor TFET de mémorisation et une première électrode du deuxième transistor TFET de mémorisation forme le point mémoire, la première électrode du premier transistor TFET de mémorisation pouvant correspondre à son drain lorsque le premier transistor TFET de mémorisation est de type n ou à sa source lorsque le premier transistor TFET de mémorisation est de type p, la première électrode du deuxième transistor TFET de mémorisation pouvant correspondre à sa source lorsque le deuxième transistor TFET de mémorisation est de type n ou à son drain lorsque le deuxième transistor TFET de mémorisation est de type p ;
la cellule mémoire pouvant comporter en outre des moyens de polarisation des premier et deuxième transistors TFET de mémorisation aptes à appliquer sur une deuxième électrode du deuxième transistor TFET de mémorisation, pouvant correspondre à son drain lorsque sa première électrode correspond à sa source ou correspondre à sa source lorsque sa première électrode correspond à son drain, et sur une deuxième électrode du premier transistor TFET de mémorisation, pouvant correspondre à sa source lorsque sa première électrode correspond à son drain ou correspondre à son drain lorsque sa première électrode correspond à sa source, des potentiels électriques différents et tels que quelle que soit la valeur d'un potentiel électrique du point mémoire, l'un des premier et deuxième transistors TFET de mémorisation soit polarisé en inverse et l'autre des premier et deuxième transistors TFET de mémorisation soit polarisé avec une tension V_{DS} sensiblement nulle.

Une telle cellule mémoire utilise judicieusement la forme des caractéristiques statiques I_{DS}(V_{DS}) des transistors TFET de mémorisation qui sont polarisés en inverse. En effet, lorsque la valeur du potentiel électrique du point mémoire correspond à un bit à l'état « 0 », le premier transistor TFET de mémorisation est soumis à une tension V_{DS1}, entre le drain et la source du premier transistor TFET de mémorisation, correspondant à une polarisation inverse du premier transistor TFET de mémorisation, c'est-à-dire négative lorsque le premier transistor TFET de mémorisation est de type n ou positive lorsque le premier transistor TFET de mémorisation est de type p, et le deuxième transistor TFET de mémorisation est soumis à une tension V_{DS2}, entre le drain et la source du deuxième transistor TFET de mémorisation, qui est sensiblement nulle. Or, la caractéristique statique I_{DS}(V_{DS}) d'un transistor TFET polarisé en inverse présente une « bosse » au voisinage de V_{DS} = 0 V. Ainsi, dans le cas d'un bit à l'état « 0 » mémorisé, cette bosse de la caractéristique I_{DS}(V_{DS}) du deuxième transistor TFET assure ainsi une stabilité à la valeur du potentiel électrique mémorisé au niveau du point mémoire de la cellule mémoire. De même, lorsque la valeur du potentiel électrique du point mémoire correspond à un bit à l'état « 1 », la tension V_{DS1} est sensiblement nulle et la tension V_{DS2} correspond à une polarisation inverse du deuxième transistor TFET de mémorisation. Dans ce cas, la bosse de la caractéristique I_{DS}(V_{DS}) du premier transistor TFET assure la stabilité à la valeur du potentiel électrique mémorisé au niveau du point mémoire de la cellule mémoire.

En outre, une telle cellule mémoire fait appel à un moins grand nombre de transistors qu'une cellule mémoire comportant un élément bistable formé de deux inverseurs montés tête-bêche, assurant ainsi une forte compacité à la cellule mémoire.

De plus, le fonctionnement en polarisation inverse des transistors TFET de mémorisation permet d'avoir de très faibles courants de fuite au niveau des transistors de mémorisation.

Enfin, une telle cellule mémoire permet une lecture et une écriture très rapide du bit destiné à être mémorisé.

Les deux transistors TFET de mémorisation peuvent être de type n ou p, ou l'un des deux transistors TFET de mémorisation peut être de type n et l'autre de type p.

Les moyens de polarisation des premier et deuxième transistors TFET de mémorisation peuvent être aptes à appliquer sur la deuxième électrode du deuxième transistor TFET de mémorisation un premier potentiel électrique de valeur sensiblement égale à une première valeur du potentiel électrique du point mémoire correspondant à un état « 0 » du bit, et à appliquer sur la deuxième électrode du premier transistor TFET de mémorisation un deuxième potentiel électrique de valeur sensiblement égale à une deuxième valeur du potentiel électrique du point mémoire correspondant à un état « 1 » du bit.

La valeur du premier potentiel électrique, ou première valeur, peut être égale à environ 0 V, et/ou la valeur du deuxième potentiel électrique, ou deuxième valeur, peut être comprise entre environ 0,3 V et 1 V, ou entre environ 0,3 V et 0,6 V.

Les moyens de polarisation des premier et deuxième transistors TFET de mémorisation et les premier et deuxième transistors TFET de mémorisation peuvent être tels que, lorsque la valeur du potentiel électrique du point mémoire est égale à celle du premier potentiel électrique, une valeur d'un courant I_{DS1} traversant le premier transistor TFET de mémorisation soit comprise entre environ 1 fA/µm et 10 pA/µm (par µm de largeur de canal) et tels que, lorsque la valeur du potentiel électrique du point mémoire est égale à celle du deuxième potentiel électrique, une valeur d'un courant I_{DS2} traversant le deuxième transistor TFET de mémorisation soit comprise entre environ 1 fA/µm et 10 pA/µm. La stabilité de la valeur du potentiel électrique mémorisé au niveau du point mémoire est encore plus améliorée du fait que les caractéristiques statiques I_{DS}(V_{DS}) des transistors TFET de mémorisation qui sont polarisés en inverse comportent, en dessous d'une certaine valeur de la tension V_{DS}, une région présentant un effet de résistance négative différentielle, et que dans la configuration ci-dessus, ces régions coopèrent avec les bosses des caractéristiques statiques I_{DS}(V_{DS}) afin d'assurer la stabilité de la valeur du bit mémorisé.

Les moyens de polarisation des premier et deuxième transistors TFET de mémorisation peuvent être aptes à appliquer un potentiel électrique V_{GG1} sur la grille du premier transistor TFET de mémorisation et un potentiel électrique V_{GG2} sur la grille du deuxième transistor TFET de mémorisation tels que :
- lorsque les premier et deuxième transistors TFET de mémorisation sont de type n, les valeurs des potentiels électriques V_{GG1} et V_{GG2} sont supérieures ou égales à celle du deuxième potentiel électrique, ou supérieures ou égales au double de la valeur du deuxième potentiel électrique, ou comprises entre environ 0,6 V et 2 V ou entre environ 0,6 V et 1,2 V ;
- lorsque le premier transistor TFET de mémorisation est de type n et le deuxième transistor TFET de mémorisation est de type p, la valeur du potentiel électrique V_{GG1} est supérieure ou égale à celle du deuxième potentiel électrique, ou supérieure ou égale au double de la valeur du deuxième potentiel électrique, ou comprise entre environ 0,6 V et 2 V ou entre environ 0,6 V et 1,2 V, et la valeur du potentiel électrique V_{GG2} est inférieure ou égale à 0 ;
- lorsque le premier transistor TFET de mémorisation est de type p et le deuxième transistor TFET de mémorisation est de type n, la valeur du potentiel électrique V_{GG1} est inférieure ou égale 0 et la valeur du potentiel électrique V_{GG2} est supérieure ou égale à celle du deuxième potentiel électrique, ou supérieure ou égale au double de la valeur du deuxième potentiel électrique, ou comprise entre environ 0,6 V et 2 V ou entre environ 0,6 V et 1,2 V ;
- lorsque les deux transistors TFET de mémorisation sont de type p, la valeur du potentiel électrique V_{GG1} est inférieure ou égale 0 et la valeur du potentiel électrique V_{GG2} est inférieure ou égale à l'opposée de celle du deuxième potentiel électrique.

Par exemple, lorsque les premier et deuxième transistors TFET de mémorisation sont de type n, dans une première configuration, la valeur de V_{GG1} peut être égale à la valeur du deuxième potentiel électrique et la valeur de V_{GG2} peut être égale au double de la valeur du deuxième potentiel électrique, et dans une deuxième configuration, les valeurs de V_{GG1} et V_{GG2} peuvent être chacune égale au double de la valeur du deuxième potentiel électrique.

En variante, les transistors de mémorisation peuvent correspondre à au moins quatre transistors TFET et/ou CMOS reliés entre eux en formant un élément bistable comportant deux inverseurs montés tête-bêche.

La cellule mémoire peut comporter en outre au moins un transistor MOS d'écriture, de type n ou p, dont une première électrode, correspondant à sa source ou à son drain est reliée au point mémoire, dont une deuxième électrode, correspondant respectivement à son drain ou à sa source, est apte à recevoir un signal de données correspondant au bit, et dont une grille est apte recevoir un signal de commande d'écriture dans la cellule mémoire.

En variante, la cellule mémoire peut comporter en outre au moins :
- un premier transistor TFET d'écriture dont une première électrode, correspondant à sa source lorsque le premier transistor TFET d'écriture est de type n ou à son drain lorsque le premier transistor TFET d'écriture est de type p, est reliée au point mémoire, dont une deuxième électrode, correspondant à son drain lorsque le premier transistor TFET d'écriture est de type n ou à sa source lorsque le premier transistor TFET d'écriture est de type p, est apte à recevoir un premier signal de données de valeur correspondant à l'état « 1 » du bit, et dont la grille est apte recevoir un premier signal de commande d'écriture de l'état « 1 » du bit dans la cellule mémoire ;
- un deuxième transistor TFET d'écriture dont une première électrode, correspondant à son drain lorsque le deuxième transistor TFET d'écriture est de type n ou à sa source lorsque le deuxième transistor TFET d'écriture est de type p, est reliée au point mémoire, dont une deuxième électrode, correspondant à sa source lorsque le deuxième transistor TFET d'écriture est de type n ou à son drain lorsque le deuxième transistor TFET d'écriture est de type p, est apte à recevoir un deuxième signal de données de valeur correspondant à l'état « 0 » du bit, et dont la grille est apte recevoir un deuxième signal de commande d'écriture de l'état « 0 » du bit dans la cellule mémoire.

Une telle variante a pour avantage de permettre un entrelacement de bits grâce aux premier et deuxième signaux de commande d'écriture utilisés.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une cellule mémoire, objet de la présente invention, selon un premier mode de réalisation ;
- la figure 2 représente la caractéristique statique I_{DS}(V_{DS}) d'un transistor TFET de type n polarisé en inverse ;
- la figure 3 représente la superposition des caractéristiques statiques I_{DS}(V_{DS}) de deux transistors TFET de mémorisation de type n polarisés en inverse d'une cellule mémoire, objet de la présente invention, intervenant dans la variation du courant traversant la cellule mémoire en fonction de la valeur du potentiel électrique du point mémoire ;
- la figure 4 représente le courant I_{DS} en fonction du potentiel de grille V_{G} dans un transistor MOS et dans un transistor TFET, pour différentes valeurs de la tension V_{DS} aux bornes de ces transistors ;
- la figure 5 représente la capacité totale de grille d'un transistor TFET en fonction du potentiel de grille V_{G}, pour différentes valeurs de la tension V_{DS} aux bornes de ce transistor ;
- la figure 6 représente le potentiel électrique du point mémoire d'une cellule mémoire, objet de la présente invention, ainsi qu'un signal de commande d'écriture lors d'une opération d'écriture de différents bits ;
- la figure 7 représente schématiquement une cellule mémoire, objet de la présente invention, selon un deuxième mode de réalisation ;
- les figures 8 à 11 représentent schématiquement différentes variantes de réalisation d'un port de lecture d'une cellule mémoire, objet de la présente invention ;
- la figure 12 représente schématiquement une cellule mémoire, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

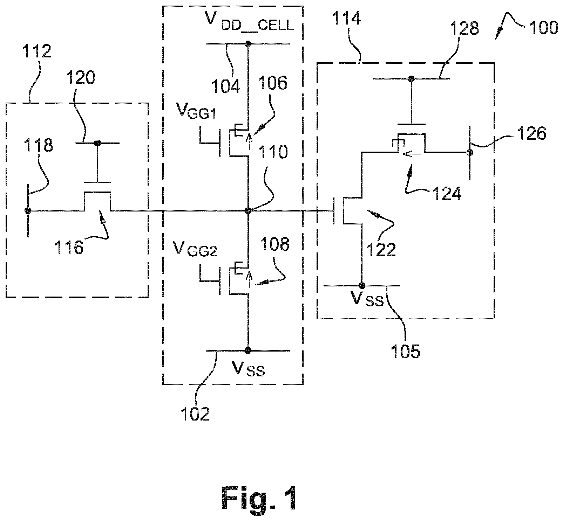

On se réfère tout d'abord à la figure 1 qui représente schématiquement une cellule mémoire 100 de type SRAM selon un premier mode de réalisation.

La cellule mémoire 100 comporte une premier borne d'alimentation électrique 102 sur laquelle est appliqué un premier potentiel électrique V_{SS} correspondant à un potentiel électrique de référence, par exemple égal à 0 V et pouvant correspondre à une masse, et une deuxième borne d'alimentation électrique 104 sur laquelle est appliqué un deuxième potentiel électrique V_{DD_CELL} correspondant à un potentiel électrique d'alimentation, qui est ici positif.

La cellule mémoire 100 comporte un premier transistor TFET 106 de mémorisation et un deuxième transistor TFET 108 de mémorisation, ici tous les deux de type n, reliés en série l'un à l'autre. Des moyens de polarisation des deux transistors TFET de mémorisation 106 et 108, non visibles sur les figures et correspondant par exemple à des moyens de génération de tensions électriques, appliquent les potentiels électriques souhaités sur les bornes d'alimentation électrique 102 et 104, ainsi que les potentiels électriques souhaités sur les grilles des transistors TFET de mémorisation 106 et 108. La source du premier transistor TFET de mémorisation 106 est reliée à la deuxième borne d'alimentation électrique 104 et le drain du premier transistor TFET de mémorisation 106 est relié à la source du deuxième transistor TFET de mémorisation 108. Le drain du deuxième transistor TFET de mémorisation 108 est relié à la première borne d'alimentation électrique 102.

Un premier potentiel électrique de grille V_{GG1} est appliqué sur la grille du premier transistor TFET de mémorisation 106 et un deuxième potentiel électrique de grille V_{GG2} est appliqué sur la grille du deuxième transistor TFET de mémorisation 108. Un point mémoire 110 de cette cellule mémoire 100 est localisé au niveau de la liaison entre le drain du premier transistor TFET de mémorisation 106 et la source du deuxième transistor TFET de mémorisation 108. L'état « 1 » ou « 0 » du bit stocké dans la cellule mémoire 100 correspond à la valeur du potentiel électrique au niveau de ce point mémoire 110.

Les potentiels électriques V_{SS} et V_{DD_CELL} appliqués sur les bornes d'alimentation électrique 102 et 104 sont tels que les transistors TFET de mémorisation 106 et 108 sont polarisés en inverse, ou fonctionnent en mode inverse, c'est-à-dire tels que les tensions V_{DS} aux bornes du drain et de la source de chacun des transistors TFET de mémorisation 106 et 108 soient négatives ou nulles. Le potentiel V_{DD_CELL} appliqué sur la deuxième borne d'alimentation électrique 104 est par exemple égal à environ 0,6 V, et le potentiel V_{SS} appliqué sur la première borne d'alimentation électrique 102 est un potentiel électrique de référence par exemple égal à environ 0 V. Avec de tels potentiels, un bit à l'état « 1 » stocké dans la cellule mémoire 100 correspond à un potentiel électrique d'environ 0,6 V au niveau du point mémoire 110, et un bit à l'état « 0 » correspond à un potentiel électrique d'environ 0 V au niveau du point mémoire 110.

La caractéristique statique d'un transistor TFET polarisé en direct (potentiel électrique appliqué sur le drain supérieur à celui appliqué sur la source, c'est-à-dire pour une tension V_{DS} positive) est sensiblement similaire à celle d'un transistor MOS du même type de conductivité et polarisé en direct. Par contre, les caractéristiques statiques de ces deux transistors diffèrent dans le cas d'une polarisation inverse.

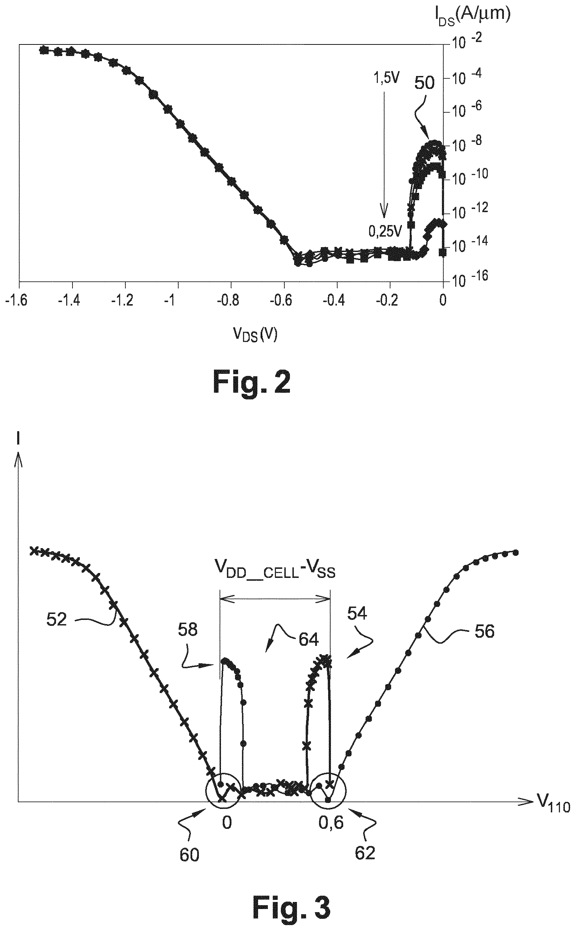

La figure 2 représente la caractéristique statique d'un transistor TFET de type n en silicium polarisé en inverse (potentiel électrique appliqué sur la source supérieur à celui appliqué sur le drain, c'est-à-dire pour une tension V_{DS} négative) similaire aux deux transistors TFET de mémorisation 106 et 108 de la cellule mémoire 100, cette caractéristique statique correspondant au courant I_{DS}, en A/µm, en fonction de la tension V_{DS}, en volts, pour différentes valeurs du potentiel V_{G} appliqué sur la grille de ce transistor TFET (entre 0,25 V et 1,5 V sur la figure 2). Sur la figure 2, l'axe des ordonnées (I_{DS}) est représenté avec une échelle logarithmique.

Pour une tension V_{DS} négative comprise entre 0 V et une première valeur égale à environ -0,15 V ou environ -0,25 V, la courbe suivie par le courant I_{DS} forme une « bosse » et le courant I_{DS} atteint, dans cette région, une valeur maximale 50 qui est égale à celle lorsque V_{DS} est nulle (environ 10⁻¹⁴ A/µm sur l'exemple de la figure 2) multipliée par un facteur compris entre environ 10³ et 10⁷ selon la valeur de la tension V_{G}. Lorsque la valeur de V_{DS} est comprise entre cette première valeur et une deuxième valeur inférieure à la première, entre environ -0,15 V et -0,6 V, ou entre environ -0,25 V et -0,6 V, sur l'exemple de la figure 2, le courant I_{DS} a une valeur sensiblement égale à celle lorsque V_{DS} est nulle. Lorsque la valeur de V_{DS} est inférieure à cette deuxième valeur, la valeur du courant I_{DS} croît (effet NDR, ou résistance négative différentielle) jusqu'à dépasser la valeur maximale référencée 50.

La « bosse » formée par la caractéristique I_{DS}(V_{DS}) d'un transistor TFET polarisé négativement pour des valeurs de V_{DS} négatives et proches de 0 est utilisée ici pour la stabilité de la mémorisation de la valeur d'un bit dans la cellule mémoire 100. En effet, étant donné la liaison série entre les deux transistors TFET de mémorisation 106 et 108, le courant circulant au niveau du point mémoire 110 et qui traverse également les deux transistors TFET de mémorisation 106 et 108 est fonction des caractéristiques I_{DS}(V_{DS}) des deux transistors TFET de mémorisation 106 et 108 polarisés en inverse.

Les deux caractéristiques I_{DS}(V_{DS}) des deux transistors TFET de mémorisation 106 et 108 sont représentées ensemble sur la figure 3 en fonction de la valeur du potentiel électrique V₁₁₀ au point mémoire 110, et pour une tension V_{DD_CELL} de valeur proche ou égale à l'opposé de la deuxième valeur des caractéristiques I_{DS}(V_{DS}) des transistors TFET de mémorisation 106 et 108 (celle en dessous de laquelle le phénomène de résistance négative différentielle est obtenu), par exemple environ 0,6 V. La courbe référencée 52 correspond à la caractéristique I_{DS}(V_{DS}) du premier transistor TFET de mémorisation 106. Cette courbe 52 forme une « bosse » référencée 54 lorsque la valeur du potentiel V₁₁₀ est proche ou égale à celle de V_{DD_CELL} (qui correspond à V_{DS1} nulle entre le drain et la source du premier transistor TFET de mémorisation 106), c'est-à-dire à environ 0,6 V dans l'exemple décrit ici. La courbe référencée 56 correspond à la caractéristique I_{DS}(V_{DS}) du deuxième transistor TFET de mémorisation 108, et forme une « bosse » référencée 58 lorsque la valeur du potentiel V₁₁₀ est proche ou égale à celle de V_{SS} (qui correspond à V_{DS2} nulle entre le drain et la source du deuxième transistor TFET de mémorisation 108), c'est-à-dire 0 V.

La superposition des deux caractéristiques statiques I_{DS}(V_{DS}) représentées sur la figure 3 montre que le courant circulant au niveau du point mémoire 110 est stable en deux points référencés 60 et 62 sur la figure 3. La différence entre les valeurs de ces deux points stables 60 et 62 est égale à la valeur V_{DD_CELL} - Vss, c'est-à-dire la tension d'alimentation des deux transistors TFET de mémorisation 106 et 108. Au point référencé 60, qui correspond au cas où la valeur du potentiel V₁₁₀ est sensiblement égale à celle du potentiel Vss, le potentiel V₁₁₀ est stable car la bosse 58 formée par la caractéristique I_{DS}(V_{DS}) du deuxième transistor TFET de mémorisation 108 maintient le potentiel V₁₁₀ à cette valeur si celui-ci tend à augmenter et le phénomène de résistance négative différentielle qui apparaît pour la caractéristique I_{DS}(V_{DS}) du premier transistor TFET de mémorisation 106 pour des valeurs inférieures à V_{SS} maintient également cette valeur du potentiel V₁₁₀ si celui-ci tend à diminuer. De même, au point référencé 62 qui correspond au cas où la valeur du potentiel V₁₁₀ est sensiblement égale à celle du potentiel V_{DD_CELL}, le potentiel V₁₁₀ est stable car la bosse 54 formée par la caractéristique I_{DS}(V_{DS}) du premier transistor TFET de mémorisation 106 maintient le potentiel V₁₁₀ à cette valeur si celui-ci tend à diminuer et le phénomène de résistance négative différentielle qui apparaît pour la caractéristique I_{DS}(V_{DS}) du deuxième transistor TFET de mémorisation 108 pour des valeurs supérieures à V_{DD_CELL} maintient également cette valeur du potentiel V₁₁₀ si celui-ci tend à augmenter. Un bit à l'état « 0 » peut donc être mémorisé dans la cellule mémoire 100 en fixant la valeur du potentiel V₁₁₀ à la valeur du point référencé 60, c'est-à-dire la valeur de Vss, par exemple environ 0 V, et un bit à l'état « 1 » peut être mémorisé dans la cellule mémoire 100 en fixant la valeur du potentiel V₁₁₀ à la valeur du point référencé 62, c'est-à-dire la valeur de V_{DD_CELL}, par exemple environ 0,6 V.

Une région 64 se trouvant entre les deux bosses 54 et 58 est considérée comme étant une région non-déterminée en ce qui concerne l'état du bit mémorisé par la cellule 100. En effet, si la valeur du potentiel V₁₁₀ se trouve dans cette région 64, par exemple à une valeur comprise entre environ 0,2 V et 0,4 V lorsque V_{SS} = 0V et V_{DD_CELL} = 0,6 V, il n'est pas possible de retrouver la valeur de ce potentiel car celle-ci peut varier au sein de cette région 64, la cellule mémoire 100 étant dans ce cas considérée comme étant dans un état de haute impédance. Pour mémoriser un bit à l'état « 0 » ou « 1 », la valeur du potentiel V₁₁₀ n'est donc pas fixée dans la gamme de valeurs correspondant à cette région 64.

Aux points de mémorisation 60 et 62, la valeur du courant circulant au niveau du point mémoire 110 correspond aux courants I_{DS1} et I_{DS2} traversant les deux transistors TFET de mémorisation 106 et 108 et dépend donc de la structure des transistors TFET de mémorisation 106 et 108 utilisés dans la cellule mémoire 100. Les transistors TFET de mémorisation 106 et 108 utilisés sont de préférence tels que la valeur de ce courant soit faible aux points de mémorisation 60 et 62, et par exemple comprise entre environ 10 fA/µm et 10 pA/µm (valeur du courant par µm de largeur de canal), ce qui permet à la cellule mémoire 100 de consommer peu de courant lorsque celle-ci est dans un état de mémorisation d'une valeur d'un bit.

La différence entre les valeurs des potentiels V_{DD_CELL} et V_{SS} peu être inférieure à la deuxième valeur des caractéristiques I_{DS}(V_{DS}) des transistors TFET de mémorisation 106 et 108, par exemple inférieure à environ 0,6 V, tout en obtenant une stabilité de l'état du bit mémorisé, la région 64 étant dans ce cas plus réduite que sur l'exemple de la figure 2. Il est notamment possible que cette différence soit telle que les bosses 54 et 58 des caractéristiques I_{DS}(V_{DS}) des transistors TFET de mémorisation 106 et 108 se superposent, la région 64 pouvant être dans ce cas inexistante.

Comme expliqué précédemment en liaison avec la figure 2, la valeur maximale du courant I_{DS} au niveau des bosses 54 et 58 dépend de la structure des transistors TFET de mémorisation 106 et 108 mais également des valeurs des potentiels V_{GG1} et V_{GG2} appliqués sur les grilles des transistors TFET de mémorisation 106 et 108. Pour assurer la meilleure stabilité possible à la cellule mémoire 100, les valeurs des potentiels V_{GG1} et V_{GG2} sont de préférence choisies les plus grandes possibles, par exemple au moins égales à V_{DD_CELL}, pour avoir le plus grand rapport possible entre la valeur du courant aux points de mémorisation 60 et 62 et les valeurs maximales des bosses, ce rapport étant par exemple compris entre environ 10³ et 10⁷.

La rapidité de lecture et d'écriture dans la cellule mémoire 100 dépend en partie de la tension d'alimentation V_{DD_CELL} - V_{SS} qui sera choisie de préférence la plus grande possible pour que la cellule mémoire 100 soit la plus rapide possible. Les transistors TFET de mémorisation 106 et 108 sont donc de préférence réalisés tels qu'ils acceptent la plus forte tension de polarisation possible. Il convient toutefois de choisir cette tension de préférence telle que la cellule mémoire 100 soit compatible avec d'autres circuits CMOS, de préférence entre environ 0,3 V et 1 V.

Dans le mode de réalisation précédemment décrit, les transistors TFET de mémorisation 106 et 108 sont en silicium, c'est-à-dire comportent des régions de source, drain et canal en silicium. En variante, l'un des transistors TFET de mémorisation 106 et 108 ou les deux transistors TFET de mémorisation 106 et 108 peuvent être à hétérojonction, c'est-à-dire comporter des régions de source et de drain à base de semi-conducteurs différents, par exemple des régions de source en germanium et des régions de drain en silicium.

Il est également possible que les transistors TFET de mémorisation 106 et 108 soient tous les deux de type p. Dans ce cas, le drain du premier transistor TFET de mémorisation 106 est relié à la deuxième borne d'alimentation électrique 104 et la source du premier transistor TFET de mémorisation 106 est reliée au drain du deuxième transistor TFET de mémorisation 108 en formant le point mémoire 110. La source du deuxième transistor TFET de mémorisation 108 est reliée à la première borne d'alimentation électrique 102. De plus, le potentiel V_{GG1} appliqué sur la grille du premier transistor TFET de mémorisation 106 est dans ce cas négatif ou nul, et le potentiel V_{GG2} appliqué sur la grille du deuxième transistor TFET de mémorisation 108 est inférieur ou égal à environ -0,6 V.

Ainsi, lorsque le bit mémorisé est à l'état « 0 », le premier transistor TFET de mémorisation 106 est polarisé en inverse avec une tension V_{DS} positive, par exemple égale à 0,6 V, et le deuxième transistor TFET de mémorisation 108 est polarisé avec une tension V_{DS} sensiblement nulle. Inversement, lorsque le bit mémorisé est à l'état « 1 », le premier transistor TFET de mémorisation 106 est polarisé avec une tension V_{DS} sensiblement nulle et le deuxième transistor TFET de mémorisation 108 est polarisé en inverse avec une tension V_{DS} positive, par exemple égale à 0,6 V. Les propriétés de la cellule mémoire 100 précédemment décrites avec deux transistors TFET de mémorisation de type n se retrouvent donc également dans cette configuration de la cellule mémoire 100 qui comporte deux transistors TFET de mémorisation de type p.

Il est également possible que les deux transistors TFET de mémorisation 106 et 108 soient de types de conductivité différents l'un par rapport à l'autre.

Il est par exemple possible que le premier transistor TFET de mémorisation 106 soit de type n et que le deuxième transistors TFET de mémorisation 108 soit de type p. Dans ce cas, la source du premier transistor TFET de mémorisation 106 est reliée à la deuxième borne d'alimentation électrique 104 et le drain du premier transistor TFET de mémorisation 106 est relié au drain du deuxième transistor TFET de mémorisation 108 en formant le point mémoire 110. La source du deuxième transistor TFET de mémorisation 108 est reliée à la première borne d'alimentation électrique 102. Le potentiel V_{GG2} appliqué sur la grille du deuxième transistor TFET de mémorisation 108 est dans ce cas négatif ou nul, et le potentiel V_{GG1} appliqué sur la grille du premier transistor TFET de mémorisation 106 est supérieur ou égal à environ 0,6 V.

Ainsi, lorsque le bit mémorisé est à l'état « 0 », le premier transistor TFET de mémorisation 106 est polarisé en inverse avec une tension V_{DS} négative, par exemple égale à -0,6 V, et le deuxième transistor TFET de mémorisation 108 est polarisé avec une tension V_{DS} sensiblement nulle. Inversement, lorsque le bit mémorisé est à l'état « 1 », le premier transistor TFET de mémorisation 106 est polarisé avec une tension V_{DS} sensiblement nulle et le deuxième transistor TFET de mémorisation 108 est polarisé en inverse avec une tension V_{DS} positive, par exemple égale à 0,6 V. Les propriétés de la cellule mémoire 100 précédemment décrites avec deux transistors TFET de mémorisation de type n se retrouvent donc également dans cette configuration de la cellule mémoire 100 qui comporte deux transistors TFET de mémorisation de types opposés.

Il est également possible que le premier transistor TFET de mémorisation 106 soit de type p et que le deuxième transistor TFET de mémorisation 108 soit de type n. Dans ce cas, le drain du premier transistor TFET de mémorisation 106 est relié à la deuxième borne d'alimentation électrique 104 et la source du premier transistor TFET de mémorisation 106 est reliée à la source du deuxième transistor TFET de mémorisation 108 en formant le point mémoire 110. Le drain du deuxième transistor TFET de mémorisation 108 est relié à la première borne d'alimentation électrique 102. Le potentiel V_{GG1} appliqué sur la grille du premier transistor TFET de mémorisation 106 est dans ce cas négatif ou nul, et le potentiel V_{GG2} appliqué sur la grille du deuxième transistor TFET de mémorisation 108 est supérieur ou égal à environ 0,6 V.

Ainsi, lorsque le bit mémorisé est à l'état « 0 », le premier transistor TFET de mémorisation 106 est polarisé en inverse avec une tension V_{DS} positive, par exemple égale à 0,6 V, et le deuxième transistor TFET de mémorisation 108 est polarisé avec une tension V_{DS} sensiblement nulle. Inversement, lorsque le bit mémorisé est à l'état « 1 », le premier transistor TFET de mémorisation 106 est polarisé avec une tension V_{DS} sensiblement nulle et le deuxième transistor TFET de mémorisation 108 est polarisé en inverse avec une tension V_{DS} négative, par exemple égale à -0,6 V. Les propriétés de la cellule mémoire 100 précédemment décrites avec deux transistors TFET de mémorisation de type n se retrouvent donc également dans cette configuration de la cellule mémoire 100 qui comporte deux transistors TFET de mémorisation de types opposés.

Par rapport à une cellule mémoire comportant un élément bistable formé de deux inverseurs montés tête-bêche, l'utilisation des deux transistors TFET de mémorisation 106 et 108 permet de réaliser une lecture environ 6,5 fois plus rapide, tout en utilisant un plus faible tension d'alimentation et en réalisant une écriture deux fois plus rapide.

Outre les deux transistors TFET de mémorisation 106 et 108 réalisant la fonction de mémorisation de la cellule mémoire 100, cette cellule mémoire 100 comporte un port d'écriture 112, permettant l'écriture de la valeur d'un bit au niveau du point mémoire 110, et un port de lecture 114 permettant la lecture de la valeur d'un bit mémorisé au point mémoire 110.

Le port d'écriture 112 comporte un transistor MOS d'écriture 116 de type p ou n, dont une première électrode, correspondant à la source ou au drain, est reliée au point mémoire 110 et dont une deuxième électrode, correspondant respectivement au drain ou à la source, est reliée à une ligne de bit d'écriture 118 (ou BLW pour « Bit Line Write »). La grille du transistor MOS d'écriture 116 est reliée à une ligne de mot d'écriture 120 (ou WLW pour « Word Line Write).

Le transistor MOS d'écriture 116 forme un transistor d'accès en écriture de la cellule mémoire 100. L'écriture d'un bit dans la cellule mémoire 100 est déclenchée via l'application d'un signal de commande d'écriture, par exemple sous la forme d'une impulsion dont l'amplitude est égale à un potentiel électrique V_{DD} qui est par exemple égal au double de V_{DD_CELL}, par exemple environ 1,2 V, sur la grille du transistor MOS d'écriture 116, via la ligne de mot d'écriture 120, rendant le transistor MOS d'écriture 116 passant pendant la durée de l'impulsion. Pendant cette opération d'écriture, un signal de données correspondant au bit à mémoriser se trouve sur la ligne de bit d'écriture 118, ce signal de données correspondant par exemple à un potentiel supérieur ou égal à V_{DD} pour un bit à l'état « 1 » et inférieur ou égal à V_{SS} (0 V) pour un bit à l'état « 0 ». Du fait que le transistor MOS d'écriture 116 est à l'état passant pendant cette opération d'écriture, un potentiel électrique se retrouve appliqué sur le point mémoire 110, celui-ci étant par exemple égal 0,6 V dans le cas d'un bit à l'état « 1 » (la tension V_{DS} aux bornes du transistor MOS d'écriture 116 étant par exemple égale à environ 0,6 V) et 0 V dans le cas d'un bit à l'état « 0 ». La valeur de ce potentiel électrique appliqué sur le point mémoire 110 correspond à la valeur de l'un des deux points de mémorisation 60 et 62 de la cellule mémoire 100 tels que précédemment décrits. L'opération d'écriture est achevée en passant le potentiel électrique appliqué sur la grille du transistor MOS d'écriture 116 à 0 V, bloquant ainsi le transistor MOS d'écriture 116. La valeur du potentiel électrique appliqué sur le point mémoire 110 pendant la période où le transistor MOS d'écriture 116 est passant se retrouve mémorisée dans la cellule mémoire 100 grâce aux deux transistors TFET de mémorisation 106 et 108 qui maintiennent ce potentiel électrique comme précédemment décrit grâce aux caractéristiques I_{DS}(V_{DS}) de ces deux transistors polarisés en inverse.

Le port de lecture 114 comporte un transistor MOS de lecture 122, par exemple de type n, dont la grille est reliée au point mémoire 110 et dont la source est reliée à une troisième borne d'alimentation électrique 105 se trouvant ici au potentiel de référence V_{SS}. Des moyens de polarisation du port de lecture 114, non visibles sur les figures et correspondant par exemple à des moyens de génération de tensions électriques, permettent d'appliquer le potentiel électrique souhaité sur cette troisième borne d'alimentation électrique 105. Le port de lecture 114 comporte également un transistor TFET de lecture 124, ici de type n, dont la source est reliée au drain du transistor MOS de lecture 122, dont le drain est relié à une ligne de bit de lecture 126 (ou BLR pour « Bit Line Read ») et dont la grille est reliée à une ligne de mot de lecture 128 (ou WLR pour « Word Line Read »).

Préalablement à une lecture du bit mémorisé au point mémoire 110, le potentiel électrique de la ligne de bit de lecture 126 est pré-chargé à V_{DD}, par exemple environ 1,2 V. Le transistor TFET de lecture 124 est rendu ensuite passant via l'application d'un signal de commande de lecture, correspondant par exemple à une impulsion de potentiel égal à V_{DD}, sur sa grille depuis la ligne de mot de lecture 128. Selon la valeur du bit mémorisé au point mémoire 110, le transistor MOS de lecture 122 est donc passant (bit à l'état « 1 ») ou non (bit à l'état « 0 »), ce qui entraîne une décharge ou non d'un courant depuis la ligne de bit de lecture 126 à travers le transistor MOS de lecture 122 et le transistor TFET de lecture 124 selon la valeur du bit mémorisé.

L'utilisation conjointe du transistor MOS de lecture 122 et du transistor TFET de lecture 124 au sein du port de lecture 114 permet une lecture rapide de l'état du bit mémorisé dans la cellule mémoire 100 (lecture pouvant être réalisée en environ 1 ns), tout en ayant de faibles courants de fuite au niveau du port de lecture 114.

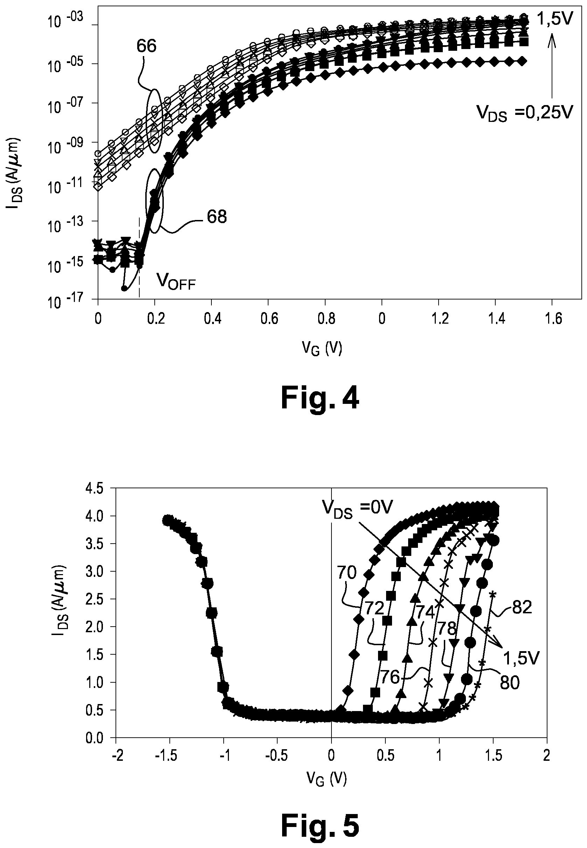

Les courbes 66 représentées sur la figure 4 correspondent à la valeur du courant I_{DS}, en A/µm, en fonction du potentiel électrique V_{G}, en volts, appliqué sur la grille d'un transistor de type NMOS, pour une tension V_{DS} allant de 0,25 V à 1,5 V. Les courbes 68 représentent la valeur du courant I_{DS} en fonction du potentiel électrique V_{G} appliqué sur la grille d'un transistor TFET de type n, pour une tension V_{DS} allant de 0,25 V à 1,5 V. Ces courbes illustrent clairement que pour des valeurs de V_{DS} et V_{G} données, la valeur du courant I_{off} d'un transistor TFET à l'état bloqué est bien inférieure à celle du courant I_{off} d'un transistor MOS à l'état bloqué. De plus, à V_{DS} et V_{G} données, la valeur du courant Iₒₙ d'un transistor TFET à l'état passant est également légèrement inférieure à celle du courant Iₒₙ d'un transistor MOS à l'état passant. Ainsi, la présence du transistor TFET de lecture 124 dans le chemin allant de la ligne de bit de lecture 126 à la troisième borne d'alimentation électrique 105 permet de réduire fortement les courants de fuite par rapport au cas d'un port de lecture comportant uniquement des transistors MOS. Dans l'exemple décrit ici, les courants de fuite sont inférieurs à environ 10 fA/µm. Cette réduction des courants de fuite se traduit donc par une réduction de la consommation électrique de la cellule mémoire 100.

Les courbes 70 à 82 représentées sur la figure 5 correspondent à la valeur de la capacité totale de grille (somme des différentes capacités dans le transistor), en fF/µm, en fonction du potentiel V_{G}, en volts, appliqué sur la grille d'un transistor TFET de type n, pour une tension V_{DS} allant de 0 V à 1,5 V (courbe 70 : V_{DS} = 0 V ; courbe 72 : V_{DS} = 0,25 V ; courbe 74 : V_{DS} = 0,5 V ; courbe 76 : V_{DS} = 0,75 V ; courbe 78 : V_{DS} = 1 V ; courbe 80 : V_{DS} = 1,25 V ; courbe 82 : V_{DS} = 1,5 V). Ces courbes illustrent le fait que pour une valeur de V_{G} donnée, la valeur de cette capacité diminue lorsque la tension V_{DS} augmente. De plus, la valeur de cette capacité pour un transistor MOS est supérieure à celle d'un transistor TFET, pour des valeurs données de V_{G} et V_{DS}. Ainsi, la faible capacité du transistor TFET de lecture 124 contribue à la réduction des courants de fuite à travers les éléments du port de lecture 114. En outre, la faible capacité du transistor TFET de lecture 124 ne pénalise pas la vitesse de lecture par rapport à un port de lecture qui serait formé uniquement de transistors MOS, et permet en outre d'obtenir une vitesse de lecture supérieure à celle d'un port de lecture formé uniquement de transistors TFET. Cela est dû notamment à la faible capacité obtenue entre la ligne de bit de lecture 126 et la ligne de mot de lecture 128 grâce au transistor TFET de lecture 124. De plus, le fait que le potentiel de la ligne de bit de lecture 126 soit pré-chargé à V_{DD} augmente la valeur de la tension V_{DS} aux bornes du transistor TFET de lecture 124, ce qui réduit la valeur de la capacité vue depuis la ligne de bit de lecture 126.

Le tableau ci-dessous indique, pour différentes combinaisons MOS / TFET des transistors 122 et 124, les vitesses de décharge obtenues sur une ligne de bit de lecture 126 de capacité égale à 30 fF lors de la lecture d'un bit, ainsi que les fuites de courant mesurées au niveau de ces transistors dans le cas d'un bit à l'état « 1 » stocké (cas où les courants des fuite sont les plus importants).

| **Transistors** | **Vitesse décharge BLR (mV/ns)** | **Courant de fuite** |
|---|---|---|
| 122 : MOS - 124 : MOS | 140 | 5,36 pA |
| 122 : MOS - 124 : TFET | 110 | < 1fA |
| 122 : TFET- 124: MOS | 40 | < 1fA |
| 122 : TFET - 124 : TFET | 30 | < 1fA |

Une lecture d'un bit peut être réalisée à partir d'une décharge d'environ 200 mV, voire même moins comme par exemple 100 mV.

Ce tableau illustre que la configuration du port de lecture 114 avec le transistor MOS de lecture 122 et le transistor TFET de lecture 124 représente la meilleure configuration en termes de vitesse de lecture et de courants de fuite.

La cellule mémoire 100 de la figure 1 correspond à une cellule mémoire à 5 transistors TFET/MOS. Les transistors MOS 116 et 122 sont par exemple réalisés en technologie 32 nm. Les lignes de bit d'écriture 118 et de lecture 126 présentent par exemple chacune une capacité égale à environ 30 fF.

Lorsque les deux transistors TFET de mémorisation 106 et 108 sont de type n, la valeur du potentiel V_{GG1} appliqué sur la grille du premier transistor TFET de mémorisation 106 est par exemple égale à 1,2 V et celle du potentiel V_{GG2} appliqué sur la grille du deuxième transistor TFET de mémorisation 108 est par exemple égale à 0,6 V. Ainsi, le premier transistor TFET de mémorisation 106 fonctionne avec une tension V_{GS1} constante de 0,6 V quelle que soit la valeur du bit mémorisé dans la cellule mémoire 100, et le deuxième transistor TFET de mémorisation 108 fonctionne avec une tension V_{GS2} égale à 0,6 V lorsqu'un bit à l'état « 0 » est mémorisé au point mémoire 100 et égale à 0 V lorsqu'un bit à l'état « 1 » est mémorisé.

De même, de manière avantageuse, lorsque les deux transistors TFET de mémorisation 106 et 108 sont de type p, la valeur du potentiel V_{GG1} appliqué sur la grille du premier transistor TFET de mémorisation 106 est par exemple égale à 0 V et celle du potentiel V_{GG2} appliqué sur la grille du deuxième transistor TFET de mémorisation 108 est par exemple égale à -0,6 V. Lorsque le transistor 106 est de type n et le transistor 108 est de type p, la valeur du potentiel V_{GG1} appliqué sur la grille du premier transistor TFET de mémorisation 106 est par exemple égale à 1,2 V et celle du potentiel V_{GG2} appliqué sur la grille du deuxième transistor TFET de mémorisation 108 est par exemple égale à -0,6 V. Enfin, lorsque le transistor 106 est de type p et le transistor 108 est de type n, la valeur du potentiel V_{GG1} appliqué sur la grille du premier transistor TFET de mémorisation 106 est par exemple égale à 0 V et celle du potentiel V_{GG2} appliqué sur la grille du deuxième transistor TFET de mémorisation 108 est par exemple égale à 0,6 V.

Le tableau ci-dessous donne des exemples de valeurs des potentiels électriques mis en jeu dans la cellule mémoire 100 pendant des opérations de lecture et d'écriture, ainsi que pendant une phase de mémorisation n'impliquant ni lecture ni écriture dans la cellule mémoire 100, et également dans un mode d'attente (« standby mode ») qui permet de limiter les fuites de courant dans la cellule mémoire 100 lorsque ni une lecture ni une écriture est réalisée et qu'une opération de lecture n'est pas imminente.

| | **Lecture** | **Ecriture** | **Mémorisation** | **Attente** |
|---|---|---|---|---|
| **WLW** | 0 V | 1,2 V | 0 V | 0 V |
| **BLW** | 0 V | 0 V ou 1,2 V | 0 V | 0 V |
| **V_{DD_CELL}** | 0,6 V | 0,6 V | 0,6 V | 0,6 V |
| **V_{SS}** | 0 V | 0 V | 0 V | 0 V |
| **WLR** | 1,2 V | 0 V | 0 V | 0 V |
| **BLR** | Flottante | 1,2 V | 1,2 V | 0 V |
| **V_{GG1}** | 1,2 V | 1,2 V | 1,2 V | 1,2 V |
| **V_{GG2}** | 0,6 V | 0,6 V | 0,6 V | 0,6 V |

Dans le tableau ci-dessus, pendant une opération d'écriture, la valeur du potentiel de BLW est à 0 V ou 1,2 V suivant la valeur du bit à mémoriser. Pendant une opération de lecture, la valeur du potentiel de BLR est considérée comme flottante du fait que la ligne de bit de lecture 126 est alors déconnectée de l'alimentation pré-chargeant le potentiel de la ligne de bit de lecture 126 à V_{DD} et que la valeur de ce potentiel varie suivant la décharge ou non du courant qui se produit lors de la lecture du bit mémorisé. En outre, la valeur de BLR est de 1,2 V pendant une opération d'écriture et la phase de mémorisation en raison de la pré-charge de ce potentiel réalisée sur la ligne de bit de lecture 126 préalablement à une opération de lecture.

Lorsqu'un bit à l'état « 0 » (0 V) est mémorisé dans la cellule mémoire 100, les transistors TFET de mémorisation 106 et 108 peuvent avoir un courant de fuite d'environ 3 fA quel que soit l'opération ou le mode dans lequel se trouve la cellule mémoire 100. Lorsqu'un bit à l'état « 1 » (0,6 V) est mémorisé dans la cellule mémoire 100, les transistors TFET de mémorisation 106 et 108 peuvent avoir un courant de fuite d'environ 187 fA quel que soit l'opération ou le mode dans lequel se trouve la cellule mémoire 100.

Le tableau ci-dessous donne des exemples de valeurs concernant les largeurs W des différents transistors de la cellule mémoire 100 ainsi que les longueurs L de canal de ces transistors.

| **Transistors** | **W (nm)** | **L (nm)** |
|---|---|---|
| 106 | 100 | 30 |
| 108 | 100 | 30 |
| 116 | 100 | 50 |
| 122 | 150 | 35 |
| 124 | 150 | 30 |

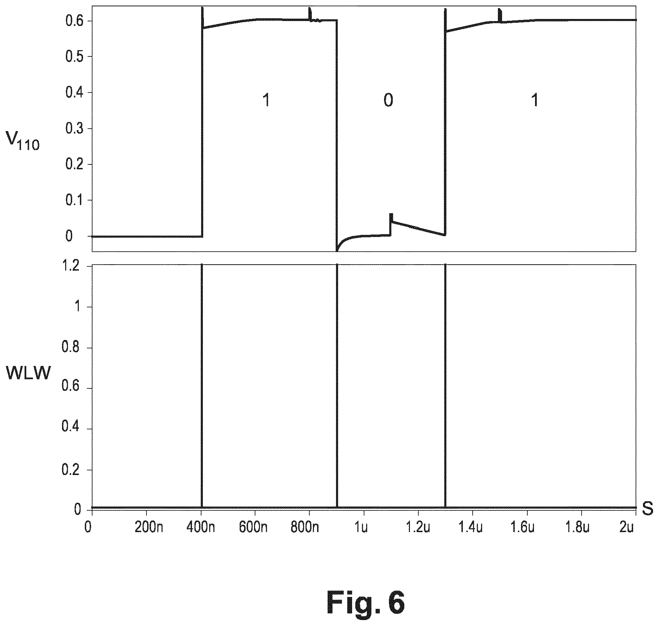

La figure 6 représente la valeur du potentiel V₁₁₀, en volts, au point mémoire 110 lors d'une opération d'écriture d'un premier bit à l'état « 1 », puis d'un deuxième bit à l'état « 0 », et enfin d'un troisième bit à l'état « 1 ». Les opérations d'écriture sont déclenchées via l'application, sur la ligne de mot d'écriture 120, d'impulsions d'amplitude de valeur égale à V_{DD} pendant une durée d'environ 400 ps, ces impulsions passant de 0 V à V_{DD} et de V_{DD} à 0 V pendant une durée d'environ 200 ps, soit une durée totale de 800 ps par impulsion. Ces impulsions sont représentées sous la courbe du potentiel V₁₁₀. Les pics de tension du potentiel V₁₁₀ aux temps 800 ns, 1,2 µs et 1,5 µs visibles sur la figure 6 sont dus à des opérations de lecture réalisées à ces temps, en raison du faible couplage capacitif formé par le transistor MOS de lecture 122.

La cellule mémoire 100 est généralement couplée à d'autres cellules mémoires formant ensemble un dispositif mémoire permettant le stockage de plusieurs bits. Les cellules mémoires peuvent être agencées sous la forme d'une matrice, en lignes et en colonnes. Les lignes de mot d'écriture 120 et les lignes de mot de lecture 128 sont par exemple communes à toutes les cellules mémoires d'une même ligne de la matrice, et les lignes de bit d'écriture 118 et les lignes de bit de lecture 126 sont par exemple communes à toutes les cellules mémoires d'une même colonne de la matrice.

Le fait que les lignes de mot d'écriture 120 sont communes à toutes les cellules mémoires d'une même ligne de la matrice implique qu'une opération d'écriture est réalisée simultanément dans toutes les cellules mémoires de la ligne. Pour que cela ne soit pas un inconvénient, la matrice de cellules mémoires peut donc comporter un grand nombre de lignes et un nombre de colonnes limité à la taille des mots, c'est-à-dire au nombre de bits des informations à mémoriser. Il est également possible de réaliser, préalablement à l'opération d'écriture, une opération de lecture des bits mémorisés par les cellules mémoires de la ligne dans lesquelles l'opération d'écriture est destinée à être réalisée. Ainsi, lorsque l'opération d'écriture est mise en oeuvre pour mémoriser de nouveaux bits dans une partie seulement des cellules mémoires de la ligne, les bits précédemment lus dans les autres cellules mémoires de la ligne (dans lesquelles de nouveaux bits ne sont pas destinés à être mémorisés) peuvent être de nouveau mémorisés dans ces autres cellules mémoires de la ligne lors de l'opération d'écriture. Ainsi, pour ces autres cellules mémoires, l'opération d'écriture ne modifie pas les valeurs des bits mémorisés dans ces cellules mémoires.

Afin d'assurer la stabilité de la mémorisation réalisée par la cellule mémoire 100, les transistors TFET de mémorisation 106 et 108 sont dimensionnés tels que la valeur maximale du courant I_{DS} de ces transistors au niveau des « bosses » de leur caractéristique I_{DS}(V_{DS}) soit supérieure à celle du courant de fuite du transistor MOS d'écriture 116 qui est de l'ordre d'un pico ampère. Il peut être avantageux de faire appel à un transistor MOS d'écriture 116 à tension de seuil élevée, c'est-à-dire un transistor à faible courant de fuite également appelé transistor LP (Low Power), pour que cette condition soit remplie, ou encore d'ajuster les largeurs et les longueurs de canal des transistors TFET de mémorisation 106 et 108. Pour limiter les fuites depuis le transistor MOS d'écriture 116, il est également possible que, dans le mode d'attente, le potentiel de la ligne de bit d'écriture 118 soit fixé à une valeur intermédiaire entre celle correspondant à un bit à l'état « 0 » et celle correspondant à un bit à l'état « 1 », par exemple environ 0,3 V.

La vitesse d'écriture dans une telle cellule mémoire 100 est supérieure à celles obtenues dans des cellules SRAM standards de type 6T ou 8T.

En variante, le transistor TFET de lecture 124 peut être de type p. Dans ce cas, le signal de commande de lecture appliqué sur sa grille lors d'une opération de lecture correspond à un potentiel électrique nul ou négatif. De plus, la source du transistor TFET de lecture 124 est dans ce cas reliée à la ligne de bit de lecture 126 et le drain du transistor TFET de lecture 124 est relié au drain du transistor MOS de lecture 122.

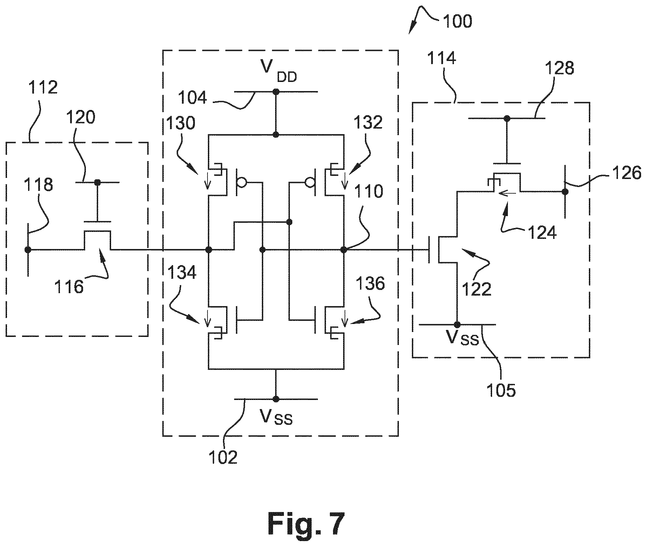

La figure 7 représente une cellule mémoire 100 selon un deuxième mode de réalisation.

Par rapport au premier mode de réalisation précédemment décrit, les deux transistors TFET de mémorisation 106 et 108 sont remplacés par quatre transistors TFET de mémorisation 130, 132, 134 et 136 reliés ensemble en formant deux inverseurs montés tête-bêche correspondant à un élément bistable, comme dans le document [2] précédemment décrit.

La grille du transistor MOS de lecture 122 est reliée au point mémoire 110 qui correspond ici au point de liaison entre le drain du transistor TFET 132 et le drain du transistor TFET 136, c'est-à-dire l'entrée d'un de deux inverseurs de l'élément bistable. En variante, le point mémoire 110 pourrait correspondre à l'entrée de l'autre de deux inverseurs, c'est-à-dire au point de liaison entre le drain du transistor TFET 130 et le drain du transistor TFET 134.

Les avantages apportés par le transistor MOS de lecture 122 et le transistor TFET de lecture 124 du port de lecture 114 de la cellule mémoire 100 selon le premier mode de réalisation se retrouvent également dans la cellule mémoire selon ce deuxième mode de réalisation.

Selon une variante, les quatre transistors de mémorisation 130, 132, 134 et 136 peuvent être de type MOS. D'autre éléments et/ou configurations peuvent être envisagés pour la réalisation des éléments de mémorisation de la cellule mémoire 100.

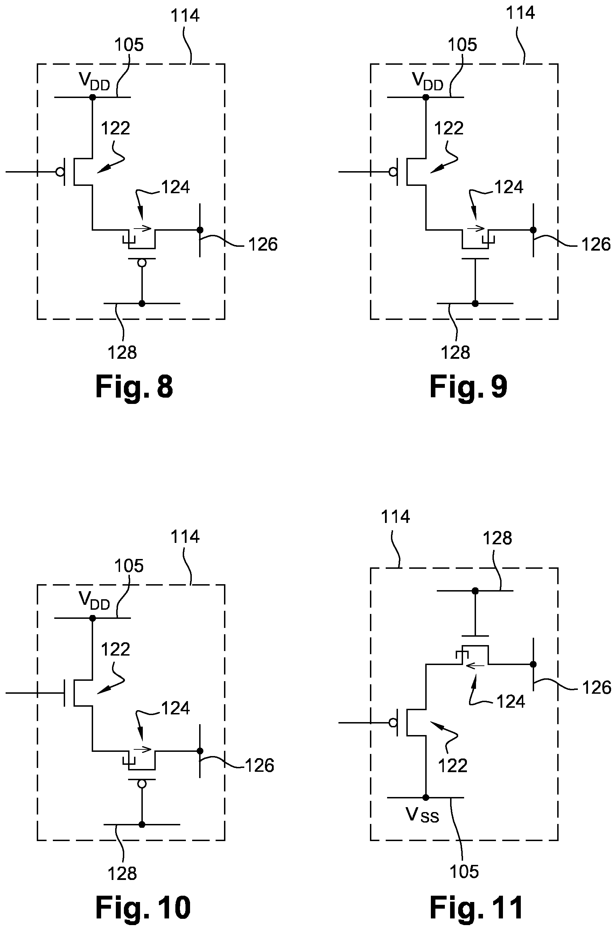

La figure 8 représente une variante de réalisation du port de lecture 114 de la cellule mémoire 100. Cette variante peut s'appliquer à la cellule mémoire 100 quels que soient les éléments de mémorisation de cette cellule (deux transistors TFET de mémorisation 106 et 108, quatre transistors MOS ou TFET de mémorisation 130, 132, 134 et 136 formant un élément bistable, etc.).

Dans cette variante, le transistor MOS de lecture 122 est de type p et comporte sa source reliée à la troisième borne d'alimentation 105 sur laquelle est appliqué le potentiel d'alimentation électrique V_{DD}, sa grille reliée aux au point mémoire 110, et son drain relié à la source du transistor TFET de lecture 124 qui est ici de type p. Le drain du transistor TFET de lecture 124 est relié à la ligne de bit de lecture 126, et la grille du transistor TFET de lecture 124 est reliée à la ligne de mot de lecture 128.

Avec ce port de lecture 114, préalablement à une lecture du bit mémorisé au point mémoire 110, le potentiel électrique de la ligne de bit de lecture 126 est pré-chargé à Vss, c'est-à-dire 0 V. Le transistor TFET de lecture 124 est rendu ensuite passant via l'application du signal de commande de lecture (correspondant à un potentiel électrique négatif, par exemple d'amplitude égale à -V_{DD}) sur sa grille depuis la ligne de mot de lecture 128. Quelle que soit la valeur du bit mémorisé au point mémoire 110, le transistor MOS de lecture 122 est passant du fait que ce transistor est de type p et que le potentiel électrique au point mémoire 110 est positif ou nul. La valeur de la pente avec laquelle la charge du courant depuis la troisième borne d'alimentation 105 à travers le transistor MOS de lecture 122 et le transistor TFET de lecture 124 se produit dépend par contre de l'état du bit mémorisé. L'état du bit mémorisé dans la cellule mémoire 100 est donc déduit de la valeur de la pente de la charge de courant se produisant dans le port de lecture 114, c'est-à-dire de la durée avec laquelle la ligne de bit de lecture 126 atteint un potentiel supérieur, par exemple V_{SS}.

L'utilisation d'un transistor MOS de lecture 122 de type p permet de s'affranchir de la contrainte liée à la valeur minimale de V_{DD_CELL} devant être appliquée sur la grille d'un transistor MOS de lecture de type n pour rendre passant ce transistor comme dans les réalisations du port de lecture 114 précédemment décrites, lors d'une lecture du bit mémorisé. En faisant appel à un transistor MOS de lecture 122 de type p, la valeur du potentiel stocké correspondant à un bit à l'état « 1 », c'est-à-dire V_{DD_CELL}, peut être abaissée à une valeur inférieure à 0,6 V, par exemple environ 0,4 V (avec dans ce cas par exemple V_{DD} = 0,8 V).

Un tel port de lecture 114 (transistor MOS de lecture 122 de type p couplé à un transistor TFET de lecture 124) a pour avantage de permettre une lecture plus rapide du bit mémorisé dans la cellule mémoire 100 par rapport à un port de lecture comportant un premier transistor MOS de lecture 122 de type n dont la grille est reliée au point mémoire 110.

Lorsque les éléments de mémorisation de cette cellule mémoire 100 correspondent aux deux transistors TFET de mémorisation 106 et 108 alimentés par le potentiel V_{DD_CELL} qui est inférieur à V_{DD}, et lors d'une opération de lecture, le premier transistor MOS de lecture 122 de type p fonctionne à V_{GS} = V_{DD} dans le cas d'une lecture d'un bit à l'état « 0 » et à V_{GS} = V_{DD} - V_{DD_CELL} dans le cas d'une lecture d'un bit à l'état « 1 ». Cette configuration permet d'avoir une bonne différenciation entre la lecture d'un bit à l'état « 0 » et celle d'un bit à l'état « 1 ».

La figure 9 représente une autre variante de réalisation du port de lecture 114 de la cellule mémoire 100. Cette variante peut s'appliquer à la cellule mémoire 100 quels que soient les éléments de mémorisation de cette cellule (deux transistors TFET de mémorisation 106 et 108, quatre transistors MOS ou TFET de mémorisation 130, 132, 134 et 136 formant un élément bistable, etc.). Par rapport à la variante de réalisation précédemment décrite en liaison avec la figure 8, le transistor TFET de lecture 124 est ici de type n, et comporte donc sa source reliée à la ligne de bit de lecture 126 et son drain relié au drain du transistor MOS de lecture 122. Le fonctionnement d'un tel port de lecture 114 est similaire à celui précédemment décrit en liaison avec la figure 8, excepté que le signal de commande de lecture appliqué sur la grille du transistor TFET de lecture 124 est positif, par exemple d'amplitude égale à V_{DD}.

La figure 10 représente une autre variante de réalisation du port de lecture 114 de la cellule mémoire 100. Cette variante peut s'appliquer à la cellule mémoire 100 quels que soient les éléments de mémorisation de cette cellule (deux transistors TFET de mémorisation 106 et 108, quatre transistors MOS ou TFET de mémorisation 130, 132, 134 et 136 formant un élément bistable, etc.). Par rapport à la variante de réalisation précédemment décrite en liaison avec la figure 8, le transistor MOS de lecture 122 est ici de type n, et comporte donc son drain relié à la troisième borne d'alimentation 105 et sa source reliée à la source du transistor TFET de lecture 124 qui est de type p.

Avec ce port de lecture 114, préalablement à une lecture du bit mémorisé dans la cellule mémoire 100, le potentiel électrique de la ligne de bit de lecture 126 est pré-chargé à V_{SS}, c'est-à-dire 0 V. Le transistor TFET de lecture 124 est rendu ensuite passant via l'application du signal de commande de lecture (potentiel négatif, par exemple -V_{DD}) sur sa grille depuis la ligne de mot de lecture 128. Selon la valeur du bit mémorisé au point mémoire 110, le transistor MOS de lecture 122 de type n est passant (bit à l'état « 1 ») ou non (bit à l'état « 0 »). La charge ou non du courant depuis la troisième borne d'alimentation 105 à travers le transistor MOS de lecture 122 et le transistor TFET de lecture 124 se produit donc selon de l'état du bit mémorisé.

Il est également possible que dans le port de lecture 114 représenté sur la figure 10, le transistor TFET de lecture 124 ne soit pas de type p mais de type n.

La figure 11 représente une autre variante de réalisation du port de lecture 114 de la cellule mémoire 100. Cette variante peut s'appliquer à la cellule mémoire 100 quels que soient les éléments de mémorisation de cette cellule (deux transistors TFET de mémorisation 106 et 108, quatre transistors MOS ou TFET de mémorisation 130, 132, 134 et 136 formant un élément bistable, etc.). Par rapport au port de lecture précédemment décrit en liaison avec la figure 1, le transistor MOS de lecture 122 est ici de type p, et comporte donc sa source reliée à la source du transistor TFET de lecture 124, ici de type n, et son drain relié à la troisième borne d'alimentation 105 qui est au potentiel V_{SS}.

Avec ce port de lecture 114, préalablement à une lecture du bit mémorisé dans la cellule mémoire 100, le potentiel électrique de la ligne de bit de lecture 126 est pré-chargé à V_{DD}, par exemple environ 1,2 V. Le transistor TFET de lecture 124 est rendu ensuite passant via l'application d'un signal de commande de lecture, correspondant par exemple à une impulsion de potentiel égal à V_{DD}, sur sa grille depuis la ligne de mot de lecture 128. Du fait que le transistor MOS de lecture 122 est de type p, quelle que soit la valeur du bit mémorisé au point mémoire 110, le transistor MOS de lecture 122 est passant. La valeur de la pente avec laquelle la décharge du courant depuis la ligne de bit de lecture 126 à travers le transistor TFET de lecture 124 et le transistor MOS de lecture 122 se produit dépend par contre de l'état du bit mémorisé. L'état du bit mémorisé dans la cellule mémoire 100 est donc déduit de la valeur de la pente de la décharge de courant se produisant dans le port de lecture 114, c'est-à-dire de la durée avec laquelle la ligne de bit de lecture 126 passe du potentiel V_{DD} à un potentiel inférieure, par exemple égal à V_{SS}.

Il est également possible que dans le port de lecture 114 représenté sur la figure 11, le transistor TFET de lecture 124 ne soit pas de type n mais de type p.

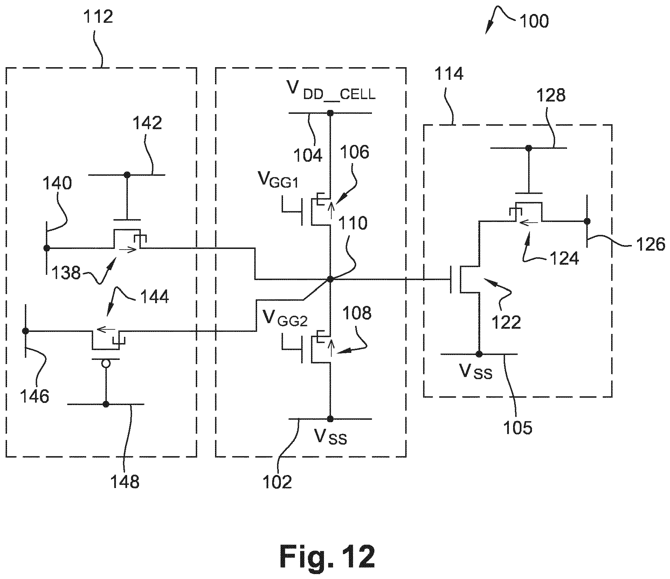

La figure 12 représente une cellule mémoire 100 selon un troisième mode de réalisation.

Comme dans le premier mode de réalisation, la fonction de mémorisation est remplie par les deux transistors TFET de mémorisation 106 et 108, ici de type n, formant le point mémoire 110 à la liaison entre le drain du premier transistor TFET de mémorisation 106 et la source du deuxième transistor TFET de mémorisation 108.

Par rapport au premier mode de réalisation précédemment décrit, le port d'écriture 112 ne comporte pas un seul transistor MOS d'écriture, mais un premier transistor TFET d'écriture 138 de type n dont la source est reliée au point mémoire 110, dont le drain est relié à une première ligne de bit d'écriture 140 (BLW1) et dont la grille est reliée électriquement à une première ligne de mot d'écriture 142 (WLW1), ainsi qu'un deuxième transistor TFET d'écriture 144 de type p dont la source est reliée au point mémoire 110, dont le drain est relié à une deuxième ligne de bit d'écriture 146 (BLW0) et dont la grille est reliée à une deuxième ligne de mot d'écriture 148 (WLW0).

Le premier transistor TFET d'écriture 138, la première ligne de bit d'écriture 140 et la première ligne de mot d'écriture 142 sont dédiés à l'écriture d'un bit à l'état « 1 » au point mémoire 110, le deuxième transistor TFET d'écriture 144, la deuxième ligne de bit d'écriture 146 et la deuxième ligne de mot d'écriture 148 étant dédiés à l'écriture d'un bit à l'état « 0 » au point mémoire 110. Selon l'état du bit à mémoriser, l'un des deux transistors TFET d'écriture 138 et 144 est mis à l'état passant via un signal de commande appliqué sur la grille du transistor correspondant via la ligne de mot d'écriture correspondante, rendant l'un des deux transistors TFET d'écriture 138 et 144 passant et réalise ainsi l'écriture de l'état souhaité du bit au point mémoire 110 grâce à un signal de données se trouvant sur la ligne de bit d'écriture correspondante.

L'écriture d'un bit à l'état « 0 » est par exemple réalisée en appliquant un potentiel électrique égal à -V_{DD_CELL} (correspondant au signal de données se trouvant sur la deuxième ligne de bit d'écriture 146) sur le drain du deuxième transistor TFET d'écriture 144, et en appliquant un potentiel électrique égal à -V_{DD_CELL} (correspondant au signal de commande se trouvant sur la deuxième ligne de mot d'écriture 148) sur la grille du deuxième transistor TFET d'écriture 144. Un potentiel négatif est appliqué sur la grille du deuxième transistor TFET d'écriture 144 qui est de type p afin d'avoir |V_{GS}| supérieure à environ 170 mV quelle que soit la valeur mémorisée au point mémoire 110 et avoir un courant de conduction direct suffisant pour la mémorisation du bit à l'état « 0 » au point mémoire 110. De plus, lors d'une mémorisation d'un bit à l'état « 0 », le signal de données se trouvant sur la deuxième ligne de bit d'écriture 146 correspond à un potentiel électrique négatif en raison de la forte dépendance du courant I_{DS} en fonction de V_{DS} dans le deuxième transistor TFET d'écriture 144, ce qui requiert une forte valeur de V_{DS} aux bornes du deuxième transistor TFET d'écriture 144 pour une décharge rapide du courant au point mémoire 110.

L'écriture d'un bit à l'état « 1 » est par exemple réalisée en appliquant un potentiel électrique égal à V_{DD} (correspondant au signal de données se trouvant sur la première ligne de bit d'écriture 140) sur le drain du premier transistor TFET d'écriture 138, et en appliquant un potentiel électrique égal à V_{DD} (correspondant au signal de commande se trouvant sur la première ligne de mot d'écriture 142) sur la grille du premier transistor TFET d'écriture 138.

Dans le mode d'attente, la deuxième ligne de mot d'écriture 145 applique un potentiel V_{DD_CELL} sur la grille du deuxième transistor TFET d'écriture 144, ce qui implique que la tension V_{GS} aux bornes du deuxième transistor TFET d'écriture 144 est nulle lorsqu'un bit à l'état « 1 » est mémorisé au point mémoire 110 ou positive lorsqu'un bit à l'état « 0 » est mémorisé au point mémoire 110. Dans le mode d'attente, un potentiel égal à V_{DD_CELL} peut également être appliqué sur la deuxième ligne de bit d'écriture 146, ce qui permet de garantir que même si le deuxième transistor TFET d'écriture 144 devient passant, l'état du bit mémorisé au point mémoire 110 n'est pas affecté car le deuxième transistor TFET d'écriture 144 est soumis soit à une tension V_{DS} nulle, soit à une tension V_{DS} négative et telle que le courant inverse traversant le deuxième transistor TFET d'écriture 144 soit négligeable.

Dans ce troisième mode de réalisation, le port de lecture 114 correspond à celui précédemment décrit pour le premier mode de réalisation, mais pourrait être réalisé selon n'importe laquelle des variantes précédemment décrites.

Dans ce troisième mode de réalisation, les potentiels de grille V_{GG1} et V_{GG2} appliqués sur les grilles du premier transistor TFET de mémorisation 106 et du deuxième transistor TFET de mémorisation 108 sont tous les deux égaux à V_{DD} (environ 1,2 V). Ainsi, le premier transistor TFET de mémorisation 106 fonctionne avec une tension V_{GS1} constante de 0,6 V quel que soit l'état du bit mémorisé dans la cellule mémoire 100, et le deuxième transistor TFET 108 de mémorisation fonctionne avec une tension V_{GS2} égale à 1,2 V lorsqu'un bit à l'état « 0 » est mémorisé au point mémoire 100 et égale à 0,6 V lorsqu'un bit à l'état « 1 » est mémorisé.

Les transistors 106, 108, 122 et 124 de cette cellule mémoire 100 sont par exemple dimensionnés comme précédemment décrit pour le premier mode de réalisation, et les transistors TFET d'écriture 138 et 144 peuvent avoir une largeur par exemple égale à 100 nm et une longueur par exemple égale à 30 nm. Les lignes de bit d'écriture 140 et 146 peuvent présenter chacune une capacité égale à environ 30 fF, comme la ligne de bit de lecture 126.

Le tableau ci-dessous donne des exemples de valeurs des potentiels électriques mis en jeu dans la cellule mémoire 100 selon le troisième mode de réalisation pendant une opération de lecture ou d'écriture, ainsi que pendant une phase de mémorisation et dans le mode d'attente.

| | **Lecture** | **Ecriture « 0 »** | **Ecriture « 1 »** | **Mémorisation** | **Attente** |
|---|---|---|---|---|---|
| **WLW1** | 0 V | 1,2 V | 1,2 V | 0 V | 0 V |
| **WLW0** | 0,6 V | - 0,6 V | - 0,6 V | 0,6 V | 0,6 V |
| **BLW1** | 0 V | 0 V | 1,2 V | 0 V | 0 V |
| **BLW0** | 0,6 V | - 0,6 V | 0,6 V | 0,6 V | 0,6 V |
| **V_{DD_CELL}** | 0,6 V | 0,6 V | 0,6 V | 0,6 V | 0,6 V |
| **V_{SS}** | 0 V | 0 V | 0 V | 0 V | 0 V |
| **WLR** | 1,2 V | 0 V | 0 V | 0 V | 0 V |
| **BLR** | Flottante | 1,2 V | 1,2 V | 1,2 V | 0 V |
| **V_{GG1}, V_{GG2}** | 1,2 V | 1,2 V | 1,2 V | 1,2 V | 1,2 V |

Dans ce troisième mode de réalisation, les phases d'écriture sont déclenchées via l'application, sur les lignes de mot d'écriture 142 et 148, de signaux de commande correspondant à des impulsions d'une durée totale d'environ 1 ns par impulsion.

Comme précédemment décrit, la cellule mémoire 100 selon le troisième mode de réalisation est généralement couplée à d'autres cellules mémoires sous la forme d'une matrice formant ensemble un dispositif mémoire permettant le stockage de plusieurs bits. Par rapport au premier mode de réalisation, la dissociation des éléments d'écriture d'un bit à l'état « 1 » et des éléments d'écriture d'un bit à l'état « 0 » permet d'éviter la réalisation d'une écriture dans toutes les cellules mémoires de la ligne de la matrice.

L'utilisation des deux transistors TFET d'écriture 138 et 144 pour réaliser l'accès en écriture de la cellule mémoire 100 a pour avantage d'apporter une grande stabilité à la cellule mémoire 100 vis-à-vis des variations liées à la température et la durée de vie de la cellule, et vis-à-vis des variations liées au procédé de réalisation de la cellule qui est mis en oeuvre et qui peuvent concerner l'épaisseur du canal, l'épaisseur de l'oxyde, le dopage de source, le travail de sortie de la grille ou encore le positionnement de la grille par rapport au canal (en particulier du côté de la source). En effet, le courant I_{OFF} d'un transistor TFET à V_{GS} = 0 V n'est pas affecté par la tension V_{DS} et de l'ordre de quelques fA à température ambiante. Une augmentation de la température à 115°C peut entraîner une augmentation du courant I_{OFF} du transistor d'environ trois décades, dans ce cas de l'ordre de quelques pA, ce qui reste significativement inférieur à la valeur maximale du courant inverse pour de faibles tensions V_{DS} négatives comme lors d'une mémorisation. De plus, le courant I_{OFF} d'un transistor TFET est insensible aux variations tant que V_{OFF} est positif. Etant donné que dans la cellule mémoire 100, V_{OFF} est d'environ 160 mV, la probabilité que cette valeur devienne négative est très faible.

L'utilisation des deux transistors TFET d'écriture 138 et 144 pour réaliser l'accès en écriture de la cellule mémoire 100 a également pour avantage de réduire les fuites de courant par rapport à l'utilisation de transistors MOS d'écriture, ces fuites étant de l'ordre de quelques fA quelle que soit la valeur du bit mémorisé, ces fuites étant également insensibles aux variations indiquées précédemment.

Dans les modes de réalisation précédemment décrits, la valeur du potentiel stocké au point mémoire 110 correspondant à un bit à l'état « 1 » est d'environ 0,6 V afin de pouvoir rendre le premier transistor MOS de lecture 122 de type n passant lorsqu'un bit à l'état « 1 » est mémorisé. Cette valeur peut toutefois être différente si le premier transistor MOS de lecture 122 de type n peut être rendu passant avec une tension différente appliquée sur sa grille. Les autres éléments de la cellule mémoire 100 sont dans ce cas adaptés aux nouveaux potentiels électriques utilisés.

Les variantes précédemment décrites en liaison avec le premier et le deuxième mode de réalisation peuvent également s'appliquer au troisième mode de réalisation.

## Revendications

1. Cellule mémoire (100) de type SRAM, comportant au moins :
- des transistors de mémorisation TFET et/ou CMOS (106, 108, 130, 132, 134, 136) formant un point mémoire (110) au niveau duquel un bit est destiné à être mémorisé ;
- un port de lecture (114) comprenant au moins un transistor MOS de lecture (122), un transistor TFET de lecture (124), une borne d'alimentation électrique (105) et une ligne de bit de lecture (126) dont un potentiel électrique est destiné à varier selon la valeur du bit mémorisé lors d'une lecture du bit mémorisé, et tel que :
- la grille du transistor MOS de lecture (122) est reliée au point mémoire (110), et la grille du transistor TFET de lecture (124) est apte à recevoir un signal de commande de lecture du bit mémorisé ;
- une première électrode du transistor MOS de lecture (122), correspondant à une source ou un drain du transistor MOS de lecture (122), est reliée à la borne d'alimentation électrique (105) ;
- une deuxième électrode du transistor MOS de lecture (122), correspondant respectivement au drain ou à la source du transistor MOS de lecture (122), est reliée à une première électrode du transistor TFET de lecture (124) correspondant à une source ou un drain du transistor TFET de lecture (124) ;
- une deuxième électrode du transistor TFET de lecture (124), correspondant respectivement au drain ou à la source du transistor TFET de lecture (124), est reliée à la ligne de bit de lecture (126).

2. Cellule mémoire (100) selon la revendication 1, comportant en outre des moyens de polarisation du port de lecture (114) aptes à appliquer un potentiel électrique de référence sur la borne d'alimentation électrique (105) tel que lors de la lecture du bit mémorisé, un courant de lecture circule à travers le transistor TFET de lecture (124) et le transistor MOS de lecture (122) depuis la ligne de bit de lecture (126) jusqu'à la borne d'alimentation électrique (105), ou aptes à appliquer un potentiel électrique d'alimentation sur la borne d'alimentation électrique (105) tel que lors de la lecture du bit mémorisé, un courant de lecture circule à travers le transistor MOS de lecture (122) et le transistor TFET de lecture (124) depuis la borne d'alimentation électrique (105) jusqu'à la ligne de bit de lecture (126).

3. Cellule mémoire (100) selon l'une des revendications précédentes, dans laquelle les transistors de mémorisation correspondent à des premier et deuxième transistors TFET de mémorisation (106, 108) reliés en série l'un à l'autre tels qu'une liaison entre une première électrode du premier transistor TFET de mémorisation (106) et une première électrode du deuxième transistor TFET de mémorisation (108) forme le point mémoire (110), la première électrode du premier transistor TFET de mémorisation (106) correspondant à son drain lorsque le premier transistor TFET de mémorisation (106) est de type n ou à sa source lorsque le premier transistor TFET de mémorisation (106) est de type p, la première électrode du deuxième transistor TFET de mémorisation (108) correspondant à sa source lorsque le deuxième transistor TFET de mémorisation (108) est de type n ou à son drain lorsque le deuxième transistor TFET de mémorisation (108) est de type p ;
la cellule mémoire (100) comportant en outre des moyens de polarisation des premier et deuxième transistors TFET de mémorisation (106, 108) aptes à appliquer sur une deuxième électrode du deuxième transistor TFET de mémorisation (108), correspondant à son drain lorsque sa première électrode correspond à sa source ou correspondant à sa source lorsque sa première électrode correspond à son drain, et sur une deuxième électrode du premier transistor TFET de mémorisation (106), correspondant à sa source lorsque sa première électrode correspond à son drain ou correspondant à son drain lorsque sa première électrode correspond à sa source, des potentiels électriques différents et tels que quelle que soit la valeur d'un potentiel électrique du point mémoire (110), l'un des premier et deuxième transistors TFET de mémorisation (106, 108) soit polarisé en inverse et l'autre des premier et deuxième transistors TFET de mémorisation (106, 108) soit polarisé avec une tension V_{DS} sensiblement nulle.

4. Cellule mémoire (100) selon la revendication 3, dans laquelle les moyens de polarisation des premier et deuxième transistors TFET de mémorisation (106, 108) sont aptes à appliquer sur la deuxième électrode du deuxième transistor TFET de mémorisation (108) un premier potentiel électrique de valeur sensiblement égale à une première valeur du potentiel électrique du point mémoire (110) correspondant à un état « 0 » du bit, et à appliquer sur la deuxième électrode du premier transistor TFET de mémorisation (106) un deuxième potentiel électrique de valeur sensiblement égale à une deuxième valeur du potentiel électrique du point mémoire (110) correspondant à un état « 1 » du bit..

5. Cellule mémoire (100) selon la revendication 4, dans laquelle la valeur du premier potentiel électrique est égale à environ 0 V, et/ou la valeur du deuxième potentiel électrique est comprise entre environ 0,3 V et 1 V.

6. Cellule mémoire (100) selon l'une des revendications 4 ou 5, dans laquelle les moyens de polarisation des premier et deuxième transistors TFET de mémorisation (106, 108) et les premier et deuxième transistors TFET de mémorisation (106, 108) sont tels que, lorsque la valeur du potentiel électrique du point mémoire (110) est égale à celle du premier potentiel électrique, une valeur d'un courant I_{DS1} traversant le premier transistor TFET de mémorisation (106) est comprise entre environ 1 fA/µm et 10 pA/µm et tels que, lorsque la valeur du potentiel électrique du point mémoire (110) est égale à celle du deuxième potentiel électrique, une valeur d'un courant I_{DS2} traversant le deuxième transistor TFET de mémorisation (108) est comprise entre environ 1 fA/µm et 10 pA/µm.

7. Cellule mémoire (100) selon l'une des revendications 4 à 6, dans laquelle les moyens de polarisation des premier et deuxième transistors TFET de mémorisation (106, 108) sont aptes à appliquer un potentiel électrique V_{GG1} sur la grille du premier transistor TFET de mémorisation (106) et un potentiel électrique V_{GG2} sur la grille du deuxième transistor TFET de mémorisation (108) tels que :
- lorsque les premier et deuxième transistors TFET de mémorisation (106, 108) sont de type n, les valeurs des potentiels électriques V_{GG1} et V_{GG2} sont supérieures ou égales à celle du deuxième potentiel électrique ;
- lorsque le premier transistor TFET de mémorisation (106) est de type n et le deuxième transistor TFET de mémorisation (108) est de type p, la valeur du potentiel électrique V_{GG1} est supérieure ou égale à celle du deuxième potentiel électrique et la valeur du potentiel électrique V_{GG2} est inférieure ou égale à 0 ;
- lorsque le premier transistor TFET de mémorisation (106) est de type p et le deuxième transistor TFET de mémorisation (108) est de type n, la valeur du potentiel électrique V_{GG1} est inférieure ou égale 0 et la valeur du potentiel électrique V_{GG2} est supérieure ou égale à celle du deuxième potentiel électrique ;
- lorsque les deux transistors TFET de mémorisation (106, 108) sont de type p, la valeur du potentiel électrique V_{GG1} est inférieure ou égale 0 et la valeur du potentiel électrique V_{GG2} est inférieure ou égale à l'opposée de celle du deuxième potentiel électrique.

8. Cellule mémoire (100) selon l'une des revendications 1 ou 2, dans laquelle les transistors de mémorisation correspondent à au moins quatre transistors TFET et/ou CMOS (130, 132, 134, 136) reliés entre eux en formant un élément bistable comportant deux inverseurs montés tête-bêche.

9. Cellule mémoire (100) selon l'une des revendications précédentes, comportant en outre au moins un transistor MOS d'écriture (116) dont une première électrode, correspondant à sa source ou à son drain, est reliée au point mémoire (110), dont une deuxième électrode, correspondant respectivement à son drain ou à sa source, est apte à recevoir un signal de données correspondant au bit, et dont une grille est apte recevoir un signal de commande d'écriture dans la cellule mémoire (100).

10. Cellule mémoire (100) selon l'une des revendications 1 à 8, comportant en outre au moins :
- un premier transistor TFET d'écriture (138) dont une première électrode, correspondant à sa source lorsque le premier transistor TFET d'écriture (138) est de type n ou à son drain lorsque le premier transistor TFET d'écriture (138) est de type p, est reliée au point mémoire (110), dont une deuxième électrode, correspondant à son drain lorsque le premier transistor TFET d'écriture (138) est de type n ou à sa source lorsque le premier transistor TFET d'écriture (138) est de type p, est apte à recevoir un premier signal de données de valeur correspondant à l'état « 1 » du bit, et dont la grille est apte recevoir un premier signal de commande d'écriture de l'état « 1 » du bit dans la cellule mémoire (100) ;
- un deuxième transistor TFET d'écriture (144) dont une première électrode, correspondant à son drain lorsque le deuxième transistor TFET d'écriture (144) est de type n ou à sa source lorsque le deuxième transistor TFET d'écriture (144) est de type p, est reliée au point mémoire (110), dont une deuxième électrode, correspondant à sa source lorsque le deuxième transistor TFET d'écriture (144) est de type n ou à son drain lorsque le deuxième transistor TFET d'écriture (144) est de type p, est apte à recevoir un deuxième signal de données de valeur correspondant à l'état « 0 » du bit, et dont la grille est apte recevoir un deuxième signal de commande d'écriture de l'état « 0 » du bit dans la cellule mémoire (100).

## Patentansprüche

1. Speicherzelle (100) vom Typ SRAM, umfassend wenigstens Folgendes:
- TFET- und/oder CMOS-Speichertransistoren (106, 108, 130, 132, 134, 136), die einen Speicherpunkt (110) bilden, in dessen Bereich ein Bit gespeichert werden soll;
- einen Leseport (114), umfassend wenigstens einen MOS-Lesetransistor (122), einen TFET-Lesetransistor (124), einen elektrischen Versorgungsanschluss (105) und eine Bitleseleitung (126), deren elektrisches Potential dazu ausgelegt ist, während eines Lesens des gespeicherten Bits gemäß dem Wert des gespeicherten Bits zu variieren, und derart, dass:
- das Gate des MOS-Lesetransistors (122) mit dem Speicherpunkt (110) verbunden ist, und das Gate des TFET-Lesetransistors (124) dazu ausgelegt ist, ein Befehlssignal zum Lesen des gespeicherten Bits zu empfangen;
- eine erste Elektrode des MOS-Lesetransistors (122), entsprechend einer Source oder einem Drain des MOS-Lesetransistors (122), mit dem elektrischen Versorgungsanschluss (105) verbunden ist;
- eine zweite Elektrode des MOS-Lesetransistors (122), entsprechend jeweils dem Drain oder der Source des MOS-Lesetransistors (122), mit einer ersten Elektrode des TFET-Lesetransistors (124) entsprechend einer Source oder einem Drain des TFET-Lesetransistors (124) verbunden ist;
- eine zweite Elektrode des TFET-Lesetransistors (124), entsprechend jeweils dem Drain oder der Source des TFET-Lesetransistors (124), mit der Bitleseleitung (126) verbunden ist.

2. Speicherzelle (100) nach Anspruch 1, ferner umfassend Mittel zur Polarisation des Leseports (114), die dazu ausgelegt sind, ein elektrisches Referenzpotential an den elektrischen Versorgungsanschluss (105) derart anzulegen, dass während des Lesens des gespeicherten Bits ein Lesestrom ausgehend von der Bitleseleitung (126) durch den TFET-Lesetransistor (124) und den MOS-Lesetransistor (122) bis zu dem elektrischen Versorgungsanschluss (105) zirkuliert, oder dazu ausgelegt sind, ein elektrisches Versorgungspotential an den elektrischen Versorgungsanschluss (105) derart anzulegen, dass während des Lesens des gespeicherten Bits ein Lesestrom ausgehend von dem elektrischen Versorgungsanschluss (105) durch den MOS-Lesetransistor (122) und den TFET-Lesetransistor (124) bis zur Bitleseleitung (126) zirkuliert.

3. Speicherzelle (100) nach einem der vorhergehenden Ansprüche, wobei die Speichertransistoren einem ersten und einem zweiten TFET-Speichertransistor (106, 108) entsprechen, die in Reihe einer mit dem anderen derart verbunden sind, dass eine Verbindung zwischen einer ersten Elektrode des ersten TFET-Speichertransistors (106) und einer ersten Elektrode des zweiten TFET-Speichertransistors (108) den Speicherpunkt (110) bildet, wobei die erste Elektrode des ersten TFET-Speichertransistors (106) ihrem Drain entspricht, wenn der erste TFET-Speichertransistor (106) vom Typ n ist, oder seiner Source, wenn der erste TFET-Speichertransistor (106) vom Typ p ist, wobei die erste Elektrode des zweiten TFET-Speichertransistors (108) seiner Source entspricht, wenn der zweite TFET-Speichertransistor (108) vom Typ n ist, oder seiner Drain, wenn der zweite TFET-Speichertransistor (108) vom Typ p ist;
wobei die Speicherzelle (100) ferner Mittel zur Polarisation des ersten und des zweiten TFET-Speichertransistors (106, 108) umfasst, die dazu ausgelegt sind, an eine zweite Elektrode des zweiten TFET-Speichertransistors (108) entsprechend seiner Drain, wenn seine erste Elektrode seiner Source entspricht, oder entsprechend seiner Source, wenn seine erste Elektrode seiner Drain entspricht, und an eine zweite Elektrode des ersten TFET-Speichertransistors (106), entsprechend seiner Source, wenn seine erste Elektrode seiner Drain entspricht, oder entsprechend seiner Drain, wenn seine erste Elektrode seiner Source entspricht, verschiedene elektrische Potentiale anzulegen, und derart, dass unabhängig vom Wert eines elektrischen Potentials des Speicherpunkts (110) einer von dem ersten und dem zweiten TFET-Speichertransistor (106, 108) invers polarisiert ist, und der andere von dem ersten und dem zweiten TFET-Speichertransistors (106, 108) mit einer Spannung V_{DS} im Wesentlichen gleich Null polarisiert ist.

4. Speicherzelle (100) nach Anspruch 3, wobei die Mittel zur Polarisation des ersten und des zweiten TFET-Speichertransistors (106, 108) dazu ausgelegt sind, an die zweite Elektrode des zweiten TFET-Speichertransistors (108) ein erstes elektrisches Potential anzulegen mit einem Wert im Wesentlichen gleich einem ersten Wert des elektrischen Potentials des Speicherpunkts (110) entsprechend einem Zustand "0" des Bits, und an die zweite Elektrode des ersten TFET-Speichertransistors (106) ein zweites elektrisches Potential anzulegen mit einem Wert im Wesentlichen gleich einem zweiten Wert des elektrischen Potentials des Speicherpunkts (110) entsprechend einem Zustand "1" des Bits.

5. Speicherzelle (100) nach Anspruch 4, wobei der Wert des ersten elektrischen Potentials ungefähr gleich 0 V ist, und/oder wobei der Wert des zweiten elektrischen Potentials zwischen ungefähr 0,3 V und 1V enthalten ist.

6. Speicherzelle (100) nach einem der Ansprüche 4 oder 5, wobei die Mittel zur Polarisation des ersten und des zweiten TFET-Speichertransistors (106, 108) und der erste und der zweite TFET-Speichertransistor (106, 108) derart sind, dass dann, wenn der Wert des elektrischen Potentials des Speicherpunkts (110) gleich jenem des ersten elektrischen Potentials ist, ein Wert eines Stroms I_{DS1}, der den ersten TFET-Speichertransistor (106) durchläuft, zwischen ungefähr 1 fA/µm und 10 pA/µm enthalten ist, und derart, dass dann, wenn der Wert des elektrischen Potentials des Speicherpunkts (110) gleich jenem des zweiten elektrischen Potentials ist, ein Wert eines Stroms I_{DS2}, der den zweiten TFET-Speichertransistor (108) durchläuft, zwischen ungefähr 1 fA/µm und 10 pA/µm enthalten ist.

7. Speicherzelle (100) nach einem der Ansprüche 4 bis 6, wobei die Mittel zur Polarisation des ersten und des zweiten TFET-Speichertransistors (106, 108) dazu ausgelegt sind, ein elektrisches Potential V_{GG1} an das Gate des ersten TFET-Speichertransistors (106) und ein elektrisches Potential V_{GG2} an das Gate des zweiten TFET-Speichertransistors (108) derart anzulegen, dass:
- wenn der erste und der zweite TFET-Speichertransistor (106, 108) vom Typ n sind, die Werte der elektrischen Potentiale V_{GG1} und V_{GG2} größer oder gleich jenem des zweiten elektrischen Potentials sind;
- wenn der erste TFET-Speichertransistor (106) vom Typ n ist, und der zweite TFET-Speichertransistor (108) vom Typ p ist, der Wert des elektrischen Potentials V_{GG1} größer oder gleich jenem des zweiten elektrischen Potentials ist, und der Wert des elektrischen Potentials V_{GG2} kleiner oder gleich 0 ist;
- wenn der erste TFET-Speichertransistor (106) vom Typ p ist, und der zweite TFET-Speichertransistor (108) vom Typ n ist, der Wert des elektrischen Potentials V_{GG1} kleiner oder gleich 0 ist, und der Wert des elektrischen Potentials V_{GG2} größer oder gleich jenem des zweiten elektrischen Potentials ist;
- wenn die zwei TFET-Speichertransistoren (106, 108) vom Typ p sind, der Wert des elektrischen Potentials V_{GG1} kleiner oder gleich 0 ist, und der Wert des elektrischen Potentials V_{GG2} kleiner oder gleich dem Gegenteil von jenem des zweiten elektrischen Potentials ist.

8. Speicherzelle (100) nach einem der Ansprüche 1 oder 2, wobei die Speichertransistoren wenigstens vier TFET- und/oder CMOS-Transistoren (130, 132, 134, 136) entsprechen, die miteinander verbunden sind, wobei sie ein bistabiles Element bilden, das zwei Inverter umfasst, die entgegengesetzt montiert sind.

9. Speicherzelle (100) nach einem der vorhergehenden Ansprüche, ferner umfassend wenigstens einen MOS-Schreibtransistor (116), wovon eine erste Elektrode, entsprechend seiner Source oder seinem Drain, mit dem Speicherpunkt (110) verbunden ist, wovon eine zweite Elektrode, jeweils entsprechend seiner Drain oder seiner Source, dazu ausgelegt ist, ein dem Bit entsprechendes Datensignal zu empfangen, und wovon ein Gate dazu ausgelegt ist, ein Befehlssignal zum Schreiben in die Speicherzelle (100) zu empfangen.

10. Speicherzelle (100) nach einem der Ansprüche 1 bis 8, ferner umfassend wenigstens Folgendes:
- einen ersten TFET-Schreibtransistor (138), wovon eine erste Elektrode, entsprechend seiner Source, wenn der erste TFET-Schreibtransistor (138) vom Typ n ist, oder seinem Drain, wenn der erste TFET-Schreibtransistor (138) vom Typ p ist, mit dem Speicherpunkt (110) verbunden ist, wovon eine zweite Elektrode, entsprechend seinem Drain, wenn der erste TFET-Schreibtransistor (138) vom Typ n ist, oder seiner Source, wenn der erste TFET-Schreibtransistor (138) vom Typ p ist, dazu ausgelegt ist, ein erstes Datensignal mit einem Wert entsprechend dem Zustand "1" des Bits zu empfangen, und wovon das Gate dazu ausgelegt ist, ein erstes Befehlssignal zum Schreiben des Zustands "1" des Bits in die Speicherzelle (100) zu empfangen;
- einen zweiten TFET-Schreibtransistor (144), wovon eine erste Elektrode, entsprechend seinem Drain, wenn der zweite TFET-Schreibtransistor (144) vom Typ n ist, oder seiner Source, wenn der zweite TFET-Schreibtransistor (144) vom Typ p ist, mit dem Speicherpunkt (110) verbunden ist, wovon eine zweite Elektrode, entsprechend seiner Source, wenn der zweite TFET-Schreibtransistor (144) vom Typ n ist, oder seiner Drain, wenn der zweite TFET-Schreibtransistor (144) vom Typ p ist, dazu ausgelegt ist, ein zweites Datensignal mit einem Wert entsprechend dem Zustand "0" des Bits zu empfangen, und wovon das Gate dazu ausgelegt ist, ein zweites Befehlssignal zum Schreiben des Zustands "0" des Bits in die Speicherzelle (100) zu empfangen.

## Claims

1. A memory cell (100) of the SRAM type, including at least:
- storage TFET and/or CMOS transistors (106, 108, 130, 132, 134, 136) forming a memory point (110) at which a bit is intended to be stored;
- a read port (114) comprising at least one read MOS transistor (122), a read TFET transistor (124), a power supply terminal (105) and a read bit line (126) whereof an electric potential is intended to vary depending on the value of the bit stored during a reading of the stored bit, and such that:
- the gate of the read MOS transistor (122) is linked to the memory point (110), and the gate of the read TFET transistor (124) is able to receive a read control signal of the stored bit;
- a first electrode of the read MOS transistor (122), corresponding to a source or a drain of the read MOS transistor (122), is linked to the power supply terminal (105);
- a second electrode of the read MOS transistor (122), respectively corresponding to the drain or the source of the read MOS transistor (122), is linked to a first electrode of the read TFET transistor (124) corresponding to a source or a drain of the read TFET transistor (124);
- a second electrode of the read TFET transistor (124), respectively corresponding to the drain or the source of the read TFET transistor (124), is linked to the read bit line (126).

2. The memory cell (100) according to claim 1, further comprising read port biasing means (114) able to apply a reference electric potential on the power supply terminal (105) such that during reading of the stored bit, a read current flows through the read TFET transistor (124) and the read MOS transistor (122) from the read bit line (126) to the power supply terminal (105), or able to apply a power supply potential on the power supply terminal (105) such that during reading of the stored bit, a read current flows through the read MOS transistor (122) and the read TFET transistor (124) from the power supply terminal (105) to the read bit line (126).

3. The memory cell (100) according to one of previous claims, wherein the storage transistors correspond to at least first and second storage TFET transistors (106, 108) linked to one another in series such that a link between a first electrode of the first storage TFET transistor (106) and a first electrode of the second storage TFET transistor (108) forms the memory point (110), the first electrode of the first storage TFET transistor (106) corresponding to its drain when the first storage TFET transistor (106) is n-type or to its source when the first storage TFET transistor (106) is p-type, the first electrode of the second storage TFET transistor (108) corresponding to its source when the second storage TFET transistor (108) is n-type or to its drain when the second storage TFET transistor (108) is p-type;
the memory cell (100) further including means for biasing the first and second storage TFET transistors (106, 108) able to apply, on a second electrode of the second storage TFET transistor (108), corresponding to its drain when its first electrode corresponds to its source or corresponding to its source when its first electrode corresponds to its drain, and on a second electrode of the first storage TFET transistor (106), corresponding to its source when its first electrode corresponds to its drain or corresponding to its drain when its first electrode corresponds to its source, different electric potentials and such that irrespective of the value of an electric potential of the memory point (110), one of the first and second storage TFET transistors (106, 108) is reverse biased and the other of the first and second storage TFET transistors (106, 108) is biased with a substantially zero voltage V_{DS}.

4. The memory cell (100) according to claim 3, wherein the means for biasing the first and second storage TFET transistors (106, 108) are able to apply, on the second electrode of the second storage TFET transistor (108), a first electric potential with a value substantially equal to a first value of the electric potential of the memory point (110) corresponding to a state "0" of the bit, and to apply, on the second electrode of the first storage TFET transistor (106), a second electric potential with a value substantially equal to a second value of the electric potential of the memory point (110) corresponding to a state "1" of the bit.

5. The memory cell (100) according to claim 4, wherein the value of the first electric potential is equal to approximately 0 V, and/or the value of the second electric potential is between approximately 0.3 V and 1 V.

6. The memory cell (100) according to one of claims 4 or 5, wherein the means for biasing the first and second storage TFET transistors (106, 108) and the first and second storage TFET transistors (106, 108) are such that, when the value of the electric potential of the memory point (110) is equal to that of the first electric potential, a value of a current I_{DS1} crossing the first storage TFET transistor (106) is between approximately 1 fA/µm and 10 pA/µm and such that, when the value of the electric potential of the memory point (110) is equal to that of the second electric potential, a value of a current I_{DS2} crossing the second storage TFET transistor (108) is between approximately 1 fA/µm and 10 pA/µm.

7. The memory cell (100) according to one of claims 4 to 6, wherein the means for biasing the first and second storage TFET transistors (106, 108) are able to apply an electric potential V_{GG1} on the gate of the first storage TFET transistor (106) and an electric potential V_{GG2} on the gate of the second storage TFET transistor (108) such that:
- when the first and second storage TFET transistors (106, 108) are n-type, the values of the electric potentials V_{GG1} and V_{GG2} are greater than or equal to those of the second electric potential;
- when the first storage TFET transistor (106) is n-type and the second storage TFET transistor (108) is p-type, the value of the electric potential V_{GG1} is greater than or equal to that of the second electric potential, and the value of the electric potential V_{GG2} is less than or equal to 0;
- when the first storage TFET transistor (106) is p-type and the second storage TFET transistor (108) is n-type, the value of the electric potential V_{GG1} is less than or equal to 0 and the value of the electric potential V_{GG2} is greater than or equal to that of the second electric potential;
- when the two storage TFET transistors (106, 108) are p-type, the value of the electric potential V_{GG1} is less than or equal to 0 and the value of the electric potential V_{GG2} is less than or equal to the opposite of that of the second electric potential.

8. The memory cell (100) according to one of claims 1 or 2, wherein the storage transistors correspond to at least four TFET and/or CMOS transistors (130, 132, 134, 136) linked to one another while forming a bistable element including two inverters mounted head-to-tail.

9. The memory cell (100) according to one of previous claims, further including at least one write MOS transistor (116), whereof a first electrode, corresponding to its source or its drain, is linked to the memory point (110), whereof a second electrode, respectively corresponding to its drain or its source, is able to receive a data signal corresponding to the bit, and a gate of which is able to receive a write command signal in the memory cell (100).

10. The memory cell (100) according to one of claims 1 to 8, further including at least:
- a first write TFET transistor (138) whereof a first electrode, corresponding to its source when the first write TFET transistor (138) is n-type or to its drain when the first write TFET transistor (138) is p-type, is connected to the memory point (110), whereof a second electrode, corresponding to its drain when the first write TFET transistor (138) is n-type or to its source when the first write TFET transistor (138) is p-type, is able to receive a first data signal with a value corresponding to state "1" of the bit, and the gate of which is able to receive a first write command signal of the state "1" of the bit in the memory cell (100);
- a second write TFET transistor (144) whereof a first electrode, corresponding to its drain when the second write TFET transistor (144) is n-type or to its source when the second write TFET transistor (144) is p-type, is connected to the memory point (110), whereof a second electrode, corresponding to its source when the second write TFET transistor (144) is n-type or to its drain when the second write TFET transistor (144) is p-type, is able to receive a second data signal with a value corresponding to state "0" of the bit, and the gate of which is able to receive a second write command signal of the state "0" of the bit in the memory cell (100).
